(19) Europäisches Patentamt
European Patent Office
Office européen des brevets

(11) **EP 2 604 644 A1**

(12) **EUROPEAN PATENT APPLICATION**
published in accordance with Art. 153(4) EPC

(43) Date of publication:
**19.06.2013 Bulletin 2013/25**

(21) Application number: **11816265.0**

(22) Date of filing: **15.06.2011**

(51) Int Cl.:
**C08G 77/20** (2006.01)  **C08F 299/08** (2006.01)
**C08G 77/14** (2006.01)  **C08L 83/06** (2006.01)
**C08L 83/07** (2006.01)  **G03F 7/075** (2006.01)

(86) International application number:
**PCT/JP2011/063727**

(87) International publication number:
**WO 2012/020599 (16.02.2012 Gazette 2012/07)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.08.2010 JP 2010181382**

(71) Applicant: **Asahi Kasei E-Materials Corporation
Chiyoda-ku
Tokyo 101-8101 (JP)**

(72) Inventors:
• **TSUGANE, Natsumi
Tokyo 101-8101 (JP)**

• **SAITO, Hideo
Tokyo 101-8101 (JP)**
• **KUSAKABE, Toru
Tokyo 101-8101 (JP)**
• **NAKAMICHI, Motonori
Tokyo 101-8101 (JP)**

(74) Representative: **Strehl Schübel-Hopf & Partner
Maximilianstrasse 54
80538 München (DE)**

(54) **PHOTOSENSITIVE SILICONE RESIN COMPOSITION**

(57)    Provided is a resin composition which gives a cured product of a photocurable resin having excellent crack resistance even when formed into a thick film, and capable of maintaining a low coefficient of linear thermal expansion, low thermal weight loss, and a low cure shrinkage. This photosensitive silicone resin composition comprises (A) a silica particle-containing condensation reaction product and (B) a photopolymerization initiator, and is characterized in that the silica particle- containing condensation reaction product (A) is a condensation reaction product of a polysiloxane compound (a) comprising a hydrolytic condensation product of one or more silane compounds represented by the following general formula (1): $R^1_{n1}SiX^1_{4-n1}$ (wherein $R^1$, n1 and $X^1$ are defined in the claims) and/or the silane compound, and silica particles (b), and has a terminal structure Si-O-Y (wherein Y is defined in the claims) which satisfies the following formula (2): $0 < [Si-O-SiR^3_3]/([Si-O-R^2] + [Si-O-SiR^3_3]) \leq 1$ (wherein $R^2$ and $R^3$ are defined in the claims), and has a photopolymerizable functional group.

**EP 2 604 644 A1**

**Description**

TECHNICAL FIELD

The present invention relates to a photosensitive silicone resin composition that is useful as a plastic lens primarily for the purpose of optical applications, replica materials, surface coating materials or imprint materials.

BACKGROUND ART

Although glass is widely used as an optical material due to its transparency, high heat resistance and light resistance, dimensional stability and the like, due to the need to replace glass with plastic for reasons such as heavy weight, susceptibility to cracking, high cost or poor productivity, various optical resins have been developed. Thermoplastic resins such as polycarbonate, polymethyl methacrylate or cycloolefin polymers are widely used as optical resins. However, the applications of thermoplastic resins are limited due to insufficient reflow heat resistance.

Although thermosetting resins of silicone are widely used as optical resins having superior reflow heat resistance, since the flexibility of the siloxane bonds of silicone thermosetting resins is low, only brittle compacts are able to be obtained when numerous crosslinking groups are introduced, and when thick compacts are attempted to be obtained, there is the disadvantage of only being able to obtain compacts having a high coefficient of linear thermal expansion and low glass transition temperature.

Various methods have been proposed for improving silicone thermosetting resins, and examples of methods for lowering coefficient of linear thermal expansion typically consist of the addition of inorganic filler. However, although these methods enable the coefficient of linear thermal expansion to be lowered, due to the large particle diameter of the inorganic filler, transparency of the resulting compact ends up being lost due to a difference in refractive indices between the inorganic filler and the silicone resin.

Amidst such circumstances, numerous colloidal silicas having a small particle diameter as described in Patent Document 1, for example, have been reported in order to improve on the aforementioned problems.

On the other hand, there is also a growing demand for switching from conventional thermosetting resins to photocurable resins in order to simplify the curing process.

The following Patent Documents 2 to 5 report photocurable resins in which colloidal silica having a small particle diameter is uniformly dispersed using a compound having a photopolymerizable functional group.

In addition, the following Patent Document 5 reports a resin composition composed of a cubic silsesquioxane, silica particles and acrylate monomer.

Prior Art Documents

Patent Documents

Patent Document 1: Japanese Patent No. 2851915
Patent Document 2: Japanese Patent No. 3072193
Patent Document 3: Japanese Unexamined Patent Publication No. 2009-102628
Patent Document 4: Japanese Patent No. 4352847
Patent Document 5: International Publication No. WO 2006-035646

SUMMARY OF THE INVENTION

Problems to be Solved by the Invention

Although the cured products described in Patent Documents 2 and 3 have superior transparency and rigidity, since they were originally designed for hard coating applications, they have the problem of low crack resistance when deposited as a thick film.

In addition, although the cured product described in Patent Document 4 can be formed into a thick film, it has poor light resistance due to the small number of siloxane bonds in the composition.

Moreover, although a cured product composed of the resin composition described in Patent Document 5 has a low coefficient of linear thermal expansion, there are numerous photopolymerizable functional groups in the composition, cure shrinkage is large, and there is also the problem of the resulting cured product becoming brittle when thickness is increased.

Amidst such circumstances, there is still a need for a photocurable resin having superior heat resistance and light resistance as well as excellent crack resistance even when formed into a thick film. In addition, since the cured products described in Patent Documents 1 to 5 contain a large number of silanol groups, volume and weight decrease considerably when the cured products are heated, thereby making precise positioning difficult and resulting in the problem of limited applications, particularly with respect to optical applications.

Thus, with the foregoing in view, an object of the present invention is to provide a resin composition that yields a cured product of a photocurable resin that has a excellent crack resistance when formed into a thick film and is capable of maintaining a low coefficient of linear thermal expansion, low thermal weight loss and low cure shrinkage.

Means for Solving the Problems

As a result of conducting extensive studies to solve the aforementioned problems, the inventors of the present invention found that the aforementioned problems can be solved by the unexpected composition described below, thereby leading to completion of the present invention.

Namely, the invention of the present application is as described below.

[1] A photosensitive silicone resin composition comprising (A) a silica particle-containing condensation reaction product and (B) a photopolymerization initiator, wherein:

the silica particle-containing condensation reaction product (A) is a condensation reaction product of polysiloxane compound (a), composed of a hydrolytic condensation product of one or more types of silane compounds represented by the following general formula (1) :

$$R^1_{n1}SiX^1_{4-n1} \qquad (1)$$

(wherein, $R^1$ represents a hydrogen atom or organic group containing 1 to 20 carbon atoms, n1 represents an integer of 0 to 3, $X^1$ represents a group selected from the group consisting of a hydroxyl group, halogen atom, alkoxy group having 1 to 6 carbon atoms and acetoxy group having 1 to 6 carbon atoms, and n1, $R^1$ and $X^1$ may each be the same or different in the case a plurality thereof is present) and/or the silane compound, and silica particles (b), a terminal structure Si-O-Y of the condensation reaction product (A) (wherein, Y represents $R^2$ or $SiR^3_3$, $R^2$ and $R^3$ represent hydrogen atoms or organic groups having 1 to 20 carbon atoms, and the plurality of $R^3$ may each be the same or different) satisfies the following formula (2) :

$$0 < [Si\text{-}O\text{-}SiR^3_3]/([Si\text{-}O\text{-}R^2] + [Si\text{-}O\text{-}SiR^3_2]) \leq 1 \qquad (2)$$

(wherein, $R^2$ and $R^3$ are as previously described), and the condensation reaction product (A) has a photopolymerizable functional group.

[2] The photosensitive silicone resin composition described in [1] above, wherein the photopolymerizable functional group equivalent of the photosensitive silicone resin composition is 0.5 mmol/g to 4.5 mmol/g.

[3] The photosensitive silicone resin composition described in [1] or [2] above, wherein the $[Si\text{-}O\text{-}SiR^3_3]$ defined in formula (2) is derived from one or more types of a silicon compound (c) represented by the following general formula (3):

$$R^3_3SiX^2 \qquad (3)$$

(wherein, $R^3$ is the same as defined in formula (2), $X^2$ represents a group selected from the group consisting of a hydroxyl group, halogen atom, alkoxy group having 1 to 6 carbon atoms and acetoxy group having 1 to 6 carbon atoms, and the plurality of $R^3$ present may be the same or different), or the following general formula (4):

$$R^3_3SiNHSiR^3_3 \qquad (4)$$

(wherein, $R^3$ is the same as defined in formula (2), and the plurality of $R^3$ present may be the same or different).

[4] The photosensitive silicone resin composition described in [1] above, wherein the silica particle-containing condensation reaction product (A) is a condensation reaction product of the polysiloxane compound (a) composed of a hydrolytic condensation product of one or more types of silane compounds represented by general formula (1), or the polysiloxane compound (a) and the silane compound, and the silica particles (b).

[5] The photosensitive silicone resin composition described in any of [1] to [4] above, wherein the $[Si-O-SiR^3{}_3]$ in formula (2) is obtained by reacting a condensation reaction product of the polysiloxane compound (a) and/or the silane compound and the silica particles (b), with the silicon compound (c).

[6] The photosensitive silicone resin composition described in any of [1] to [5], further comprising a compound (C) having a photopolymerizable functional group in a molecule thereof.

[7] The photosensitive silicone resin composition described in any of [1] to [6] above, further comprising (D) an antioxidant and/or ultraviolet absorber.

[8] The photosensitive silicone resin composition described in any of [1] to [7] above, comprising 100 parts by weight of the silica particle-containing condensation reaction product (A), 0.01 parts by weight to 50 parts by weight of the photopolymerization initiator (B), 0 parts by weight to 900 parts by weight of the compound (C) having a photopolymerizable function group in a molecule thereof, and 0 parts by weight to 50 parts by weight of the antioxidant and/or ultraviolet absorber (D).

[9] The photosensitive silicone resin composition described in any of [1] to [8] above, wherein the photopolymerizable function group in the silica particle-containing condensation reaction product (A) is derived from the polysiloxane compound (a) and/or the silicon compound (c).

[10] The photosensitive silicone resin composition described in any of [1] to [9] above, wherein the photopolymerizable functional group in the silica particle-containing condensation reaction product (A) and/or the compound (C) having a photopolymerizable functional group in a molecule thereof is at least one type selected from the group consisting of a (meth)acryloyl group, styryl group, norborneyl group, epoxy group and mercapto group.

[11] The photosensitive silicone resin composition described in any of [1] to [10] above, wherein the amount of the silica particles (b) in 100% by weight of the silica particle-containing condensation reaction product (A) is 1% by weight to 80% by weight, and the total amount of the polysiloxane compound (a) and the silicon compound (c) is 20% by weight to 99% by weight.

[12] The photosensitive silicone resin composition described in [1] above, wherein the ratio {component M/(component M + component D + component T + component Q)} x 100 of a component M to the total of the component M, a component D, a component T and a component Q in the silica particle-containing condensation reaction product (A) excluding the silica particles (b) is 1 mol% to 50 mol%.

[13] The photosensitive silicone resin composition described in any of [1] to [12] above, wherein the polysiloxane compound (a) contains a product obtained as a hydrolytic condensation product of a silane compound which uses at least the silane compound in which n1 of the silane compound represented by general formula (1) is 1.

[14] The photosensitive silicone resin composition described in any of [1] to [12] above, wherein the polysiloxane compound (a) contains a product obtained as a hydrolytic condensation product of a silane compound in which at least n1 in the silane compound represented by general formula (1) is 1, and a silane compound in which n1 is 2.

[15] The photosensitive silicone resin composition described in any of [1] to [14] above, wherein the ratio of the number of bonds that form siloxane bonds with silicon in the silica particle-containing condensation reaction product (A) to the total number of bonds that respectively form the siloxane bonds, direct bonds with hydroxyl groups and direct bonds with hydrolyzable groups is 40 mol% to 100 mol%.

[16] The photosensitive silicone resin composition described in any of [1] to [15] above, wherein the silica particles (b) are produced from an alkoxysilane by a wet method.

[17] The photosensitive silicone resin composition described in any of [1] to [16] above, wherein the mean primary particle diameter of the silica particles (b) is 1 nm to 20 nm.

[18] The photosensitive silicone resin composition described in any of [1] to [17], wherein the silicon compound (c) is a silicon compound in which $X^2$ in the silicon compound represented by general formula (3) is a halogen atom.

[19] The photosensitive silicone resin composition described in any of [1] to [18], wherein the photopolymerizable functional group in the silica particle-containing condensation reaction product (A) and/or the compound (C) having a photopolymerizable functional group in a molecule thereof is a (meth)acryloyl group and/or styryl group.

[20] The photosensitive silicone resin composition described in any of [1] to [18], wherein the photopolymerizable functional group in the silica particle-containing condensation reaction product (A) and/or the compound (C) having a photopolymerizable functional group in a molecule thereof is an epoxy group and/or mercapto group.

[21] The photosensitive silicone resin composition described in any of [1] to [20] above, wherein the photopolymerization initiator (B) is a photoradical polymerization initiator.

[22] The photosensitive silicone resin composition described in any of [1] to [21] above, wherein at least one type of the compound (C) having a photopolymerizable functional group in a molecule thereof contains one or more carbon rings and/or heterocycles in a molecule thereof.

[23] A production process of a photosensitive silicone resin composition, comprising the following steps:

a first step for obtaining a polysiloxane compound (a) by hydrolytically condensing one or more types of silane compounds represented by the following general formula (1):

$$R^1_{n1}SiX^1_{4-n1} \quad (1)$$

(wherein, $R^1$ represents a hydrogen atom or organic group containing 1 to 20 carbon atoms, n1 represents an integer of 0 to 3, $X^1$ represents a group selected from the group consisting of a hydroxyl group, halogen atom, alkoxy group having 1 to 6 carbon atoms and acetoxy group having 1 to 6 carbon atoms, and $R^1$ and $X^1$ may each be the same or different in the case a plurality thereof is present),
a second step for obtaining a condensation reaction product by condensing the resulting polysiloxane compound (a) and/or the silane compound with silica particles (b),
a third step for obtaining a silica particle-containing condensation reaction product (A) by condensing the resulting condensation reaction product with a silicon compound (c) represented by the following general formula (3):

$$R^3_3SiX^2 \quad (3)$$

(wherein, $R^3$ represents a hydrogen atom or organic group containing 1 to 20 carbon atoms, $X^2$ represents a group selected from the group consisting of a hydroxyl group, halogen atom, alkoxy group having 1 to 6 carbon atoms and acetoxy group having 1 to 6 carbon atoms, and the plurality of $R^3$ present may be the same or different), or the following general formula (4):

$$R^3_3SiNHSiR^3_3 \quad (4)$$

(wherein, $R^3$ is the same as defined in general formula (3)), and
a fourth step for mixing the resulting silica particle- containing condensation reaction product (A) with a photopolymerization initiator (B).

[24] A production process of a photosensitive silicone resin composition, comprising the following steps:

a first step for obtaining a polysiloxane compound (a) by hydrolytically condensing a silane compound at least including a silane compound represented by the following general formula (1):

$$R^1_{n1}SiX^1_{4-n1} \quad (1)$$

(wherein, $R^1$ represents a hydrogen atom or organic group containing 1 to 20 carbon atoms, n1 represents an integer of 0 to 3, $X^1$ represents a group selected from the group consisting of a hydroxyl group, halogen atom, alkoxy group having 1 to 6 carbon atoms and acetoxy group having 1 to 6 carbon atoms, and $R^1$ and $X^1$ may each be the same or different in the case a plurality thereof is present) in which n1 is 3,
a second step for obtaining a condensation reaction product by condensing the resulting polysiloxane compound (a) and/or the silane compound with silica particles (b),
a third step for obtaining a silica particle-containing condensation reaction product (A) by condensing the resulting condensation reaction product at with a silane compound at least including a silane compound represented by the following general formula (1):

$$R1_{n1}SiX^1_{4-n1} \quad (1)$$

(wherein, $R^1$ represents a hydrogen atom or organic group containing 1 to 20 carbon atoms, n1 represents an integer of 0 to 3, $X^1$ represents a group selected from the group consisting of a hydroxyl group, halogen atom, alkoxy group having 1 to 6 carbon atoms and acetoxy group having 1 to 6 carbon atoms, and $R^1$ and $X^1$ may each be the same or different in the case a plurality thereof is present) in which n1 is 1 or 2, and
a fourth step for mixing the resulting silica particle- containing condensation reaction product (A) with a photopolymerization initiator (B).

[25] The process described in [23] or [24] above, wherein in the first step, one or more types of silane compounds represented by general formula (1) are hydrolytically condensed under acidic conditions in an aqueous alcohol solution.

[26] The process described in [23] or [24] above, wherein in the second step, a condensation reaction product is obtained by condensing 20% by weight to 99% by weight of the polysiloxane compound (a) and 1% by weight to 80% by weight of the silica particles (b) in an aqueous solution of an alcohol having 1 to 4 carbon atoms, at a pH of 5 to 9, and at 50°C to 100°C (1 atm).

[27] The process described in [23] or [24] above, wherein in the second step, after adding at least one type of solvent having a boiling point of 100°C to 200°C (1 atm) selected from the group consisting of an alcohol, ketone, ester, ether and hydrocarbon solvent to the condensation reaction product obtained by condensing the polysiloxane compound (a) and the silica particles (b), the water content of the condensation reaction product is adjusted to 0.001% by weight to 5% by weight by distilling off the added solvent component by distillation.

[28] The process described in [23] above, wherein in the third step, after adding at least one type of solvent selected from the group consisting of an alcohol, ketone, ester, ether and hydrocarbon solvent to the condensation reaction product obtained by condensing the polysiloxane compound (a) and the silica particles (b), the silicon compound (c) represented by general formula (3) is reacted with a scavenger in the form of an organic base in an amount 0.5 times to 3 times the number of moles of the silicon compound (c) followed by removing the organic salt formed by washing with an aqueous solution to obtain the silica particle-containing condensation reaction product (A), or after adding at least one type of solvent selected from the group consisting of an alcohol, ketone, ester, ether and hydrocarbon solvent to the condensation reaction product obtained by condensing the polysiloxane compound (a) and the silica particles (b), the silicon compound (c) represented by general formula (3) is allowed to react to obtain the silica particle-containing condensation reaction product (A).

[29] The process described in [23] or [24] above, wherein in the third step, after reacting the silicon compound (c) with the condensation reaction product obtained by condensing the polysiloxane compound (a) and the silica particles (b), the solvent component in the reaction product is distilled off to obtain the silica particle-containing condensation reaction product (A).

[30] The process described in [23] or [24] above, wherein in the fourth step, a compound (C) having a photopolymerizable functional group in a molecule thereof and/or an antioxidant and/or ultraviolet absorber (D) are further mixed.

[31] A production process of a cured product of a photosensitive silicone resin composition, comprising: a step for irradiating the photosensitive silicone resin composition described in any of [1] to [22] above with light having a dominant wavelength of 200 nm to 500 nm.

[32] A cured product obtained according to the process described in [31] above.

[33] The process described in [31] above, further comprising a step for baking at 130°C to 300°C.

[34] A cured product obtained according to the process described in [33] above.

[35]A plastic lens produced according to the process described in [31] above.

[36] A replica material produced according to the process described in [31] above.

[37] A surface coating material produced according to the process described in [31] above.

Effects of the Invention

The photosensitive silicone resin composition of the present invention demonstrates little volumetric shrinkage due to irradiation with light or heat, has a excellent crack resistance after curing by irradiating with light even when a cured product of the resin is formed into a thick film, has a low coefficient of linear thermal expansion, and has low thermal weight loss.

BRIEF DESCRIPTION OF THE DRAWINGS

FIG. 1 shows the structural formulas of polysiloxane compounds (a) used to synthesize a silica particle-containing condensation reaction product (A).
FIG. 2 shows the results of $^{29}$Si-NMR for a polymer 1.
FIG. 3 shows the results of $^{29}$Si-NMR for a polymer 1 that has undergone waveform separation for a Q component.

EMBODIMENTS OF THE INVENTION

The photosensitive silicone resin composition of the present invention at least contains (A) a silica particle-containing condensation reaction product and (B) a photopolymerization initiator, and may further contain (C) a compound having a photopolymerizable functional group in a molecule thereof, and/or (D) an antioxidant and/or ultraviolet absorber. The following provides a detailed explanation of each component that composes the photosensitive resin composition according to the present invention.

<Photosensitive Silicone Resin Composition>

[Silica Particle-Containing Condensation Reaction Product

(A)]

One aspect of the present invention is a condensation reaction product of at least a polysiloxane compound (a) and/or a silane compound and silica particles (b), a terminal structure Si-O-Y (wherein, Y represents $R^2$ or $SiR^3_3$, $R^2$ and $R^3$ represent hydrogen atoms or organic groups having 1 to 20 carbon atoms, and the plurality of $R^3$ may each be the same or different) satisfies the following formula (2):

$$0 < [Si\text{-}O\text{-}SiR^3_3]/([Si\text{-}O\text{-}R^2] + [Si\text{-}O\text{-}SiR^3_2]) \leq 1 \qquad (2)$$

(wherein, $R^2$ and $R^3$ are as previously described), and the condensation reaction product has a photopolymerizable functional group. The silica particle-containing condensation reaction product (A) has high transparency, which is a characteristic of silicone resins, and has a excellent crack resistance when a cured molded product is in the form of a thick film as a result of the polysiloxane compound (a) and/or silane compound having a condensed structure. In addition, as a result of having the silica particles (b), the hardness of a cured molded product is improved, coefficient of linear thermal expansion and volumetric shrinkage during photocuring can be decreased, and as a result of the terminal structure (Si-O-Y) satisfying the aforementioned formula (2), water absorption, volumetric shrinkage caused by heating and thermal weight loss can be decreased, and a cured molded product can be obtained that has a excellent crack resistance.

[Polysiloxane Compound (a)]

The polysiloxane compound (a) used in the present invention contains a reaction product obtained by hydrolyzing (although not required in the case the component has a silanol group) and then condensing one or more types of silane compounds, or condensation products thereof, represented by the following general formula (1) :

$$R^1_{n1}SiX^1_{4-n1} \qquad (1)$$

(wherein, $R^1$ represents a hydrogen atom or organic group containing 1 to 20 carbon atoms, n1 represents an integer of 0 to 3, $X^1$ represents a group selected from the group consisting of a hydroxyl group, halogen atom, alkoxy group having 1 to 6 carbon atoms and acetoxy group having 1 to 6 carbon atoms, and n1, $R^1$ and $X^1$ may each be the same or different in the case a plurality thereof is present).

$R^1$ in the polysiloxane compound (a) is a hydrogen atom or an organic group having 1 to 20 carbon atoms. Examples of organic groups having 1 to 20 carbon atoms include acyclic or cyclic aliphatic hydrocarbon groups such as a methyl, ethyl, n-propyl, i-propyl, butyl (n-butyl, i-butyl, t-butyl or sec-butyl), pentyl (n-pentyl, i-pentyl, neopentyl or cyclopentyl), hexyl (n-hexyl, i-hexyl or cyclohexyl), heptyl (n-heptyl or i-heptyl), octyl (n-octyl, i-octyl or t-octyl), nonyl (n-nonyl or i-nonyl), decyl (n-decyl or i-decyl), undecyl (n-undecyl or i-undecyl) or dodecyl (n-dodecyl or i-dodecyl) group, acyclic or cyclic alkenyl groups such as a vinyl, propenyl, butenyl, pentenyl, hexenyl, cyclohexenyl, cyclohexenylethyl, norborneylethyl, heptenyl, octenyl, nonenyl, decenyl, undecenyl, dodecenyl or styrenyl group, aralkyl groups such as a benzyl, phenethyl, 2-methylbenzyl, 3-methylbenzyl or 4-methylbenzyl group, aralkenyl groups such as a PhCH=CH- group, aryl groups such as a phenyl group, tolyl group, styryl group or xylyl group, substituted aryl groups such as a 4-aminophenyl group, 4-hydroxyphenyl group, 4-methoxyphenyl group or 4-vinylphenyl group, and groups containing a polymerizable bonding group such as a methacryloyl group, acryloyl group, styryl group, norbornyl group, glycidyl group or mercapto group.
In addition, a portion of the main chain backbone of the various types of the aforementioned organic groups containing 1 to 20 carbon atoms may be partially substituted with a substituent selected from polar groups (polar bond) such as an ether bond, ester group (bond), hydroxyl group, thiol group, thioether group, carbonyl group, carboxyl group, carboxylic anhydride bond, thiol group, thioether bond, sulfone group, aldehyde group, epoxy group, amino group, substituted amino group, amido group (bond) imido group (bond), imino group, urea group (bond), urethane group (bond), isocyanate group or cyano group, or a halogen atom such as a fluorine atom, chlorine atom or bromine atom. $R^1$ may respectively be the same or different in the case a plurality thereof is present.
n1 in the aforementioned general formula (1) is an integer of 0 to 3.
$X^1$ respectively and independently represents a group selected from the group consisting of a hydroxyl group and hydrolyzable substituents in the form of a halogen atom, alkoxy group having 1 to 6 carbon atoms and acetoxy group having 1 to 6 carbon atoms, and specific examples thereof include hydroxyl groups, halogen atoms such as a chlorine atom, bromine atom or iodine atom, alkoxy groups such as a methoxy group, ethoxy group, n-propyloxy group, iso-propyloxy group, n-butyloxy group, t-butyloxy group, n-hexyloxy group or cyclohexyloxy group, and acetoxy groups, and among these, halogen atoms such as a chlorine atom, bromine atom or iodine atom, alkoxy groups such as a methoxy group or ethoxy group, and acetoxy groups are preferable since they demonstrate high reactivity in the condensation reaction when synthesizing the polysiloxane compound (a). $X^1$ may respectively be the same or different in the case a plurality thereof is present.
Examples of the silane compound represented by the aforementioned general formula (1) include vinyltrichlorosilane, vinyltrimethoxysilane, vinyltriethoxysilane, 2-(3,4-epoxycyclohexyl) ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2(aminoethyl-3-aminopropylmethyldimethoxysilane, N-2(aminoethyl)-3-aminopropyltrimethoxysilane, N-2(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, N-(vinylbenzyl)-2-aminoethyl- 3-aminopropyltrimethoxysilane hydrochloride, 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl) tetrasulfide, 3-isocyanatopropyltriethoxysilane, vinyltris (2-methoxyethoxy)silane, vinylmethyldimethoxysilane, 3-mercaptopropyltriethoxysilane, 3-octaonylthio-1-propyltriethoxysilane, 3-isocyanatopropyltrimethoxysilane, 3-triethoxysilyl-N-(1,3-dimethyl-butylidene), 3-acryloxypropyltrimethoxysilane, N-(p-vinylbenzyl)-N-(trimethoxysilylpropyl)ethylenediamine hydrochloride, 3-glycidoxypropylmethyldimethoxysilane, bis[3-(triethoxysilyl)propyl]disulfide, vinyltriacetoxysilane, vinyltriisopropoxysilane, allyltrimethoxysilane, diallyldimethylsilane, 3-mercaptopropyltriethoxysilane, N-(1,3-dimethylbutylidene)-3-mercaptopropyltriethoxysilane, methyltrimethoxysilane, dimethyldimethoxysilane, phenyltrimethoxysilane, tetraethoxysilane, methyltriethoxysilane, dimethyldiethoxysilane, phenyltriethoxysilane, n-propyltrimethoxysilane, n-propyltriethoxysilane, hexyltrimethoxysilane, hexyltriethoxysilane, trimethylchlorosilane, dimethylchlorosilane, methyltrichlorosilane, dimethylchlorosilane, dichloromethylsilane, trichlorosilane and other alkylchlorosilanes, dimethylvinylchlorosilane, dimethylvinyldichlorosilane, vinyltrichlorosilane and other unsaturated hydrocarbon group-containing chlorosilanes, triphenylchlorosilane, diphenylmethylchlorosilane, dimethylphenylchlorosilane, diphenyldichlorosilane, phenylmethyldichlorosilane, phenyltrichlorosilane and other aromatic group-containing chlorosilanes, dimethylcyclohexylchlorosilane, dicyclohexylmethylchlorosilane, dicyclohexyldichlorosilane, methylcyclohexyldichlorosilane, cyclohexyltrichlorosilane, dimethylcyclopentylchlorosilane, dicyclopentylmethylchlorosilane, dicyclopentyldichlorosilane, methylcyclopentyldichlorosilane, cyclopentyltrichlorosilane and other aromatic group-containing chlorosilanes, acryloxypropyldimethylchlorosilane, acryloxypropylmethyldichlorosilane, acryloxypropyltrichlorosilane, methacryloxypropyldimethylchlorosilane, methacryloxypropylmethyldichlorosilane, methacryloxypropyltrichlorosilane, styryldimethylchlorosilane, styrylmethyldichlorosilane and styryltrichlorosilane.

Although the silane compound represented by the aforementioned general formula (1) may be used alone, the use of a plurality of types of silane compounds makes it possible to control fluidity prior to curing as well as control refractive index, hardness and the like, thereby making this preferable.

In addition, the use of at least one silane compound among the silane compounds represented by general formula (1) in which n1 is 1 is preferable from the viewpoint of increasing molecular weight, and the use of a silane compound represented by general formula (1) in which n1 is 1 in combination with a silane compound represented by general formula (1) in which n1 is 2 is preferable from the viewpoint of crack resistance after curing a cured molded product.

Although the following provides an explanation of the production of the polysiloxane compound (a) using as an example the case of using a silane compound represented by the aforementioned general formula (1) and/or condensation product thereof, the present invention is not limited thereto.

The polysiloxane compound (a) is preferably produced by adding water to one or more types of silane compounds represented by general formula (1) and/or a condensation product thereof. The amount of water added is preferably within the range of 1 equivalent to 10 equivalents (molar basis), and more preferably 0.4 equivalents to 8 equivalents, of the total number of moles of $X^1$ in the silane compound represented by general formula (1). If the amount of water added is 0.1 equivalents or more, the molecular weight of the polysiloxane compound (a) increases, thereby making this preferable, while making the amount of water to be 10 equivalents or less is preferable from the viewpoint of extending the pot life of a solution of the polysiloxane compound (a) obtained by a condensation reaction. Condensation may be carried out without adding water in the case all $X^1$ of the silane compound represented by general formula (1) used in polycondensation are hydroxyl groups.

In the case of producing the polysiloxane compound (a) by a condensation reaction in the presence of a catalyst, the hydrolysis and condensation rate increase, thereby making this preferable.

Examples of types of catalysts include acid catalysts, base catalysts and metal alkoxides. Specific examples of acid catalysts include inorganic acids and organic acids. Examples of the aforementioned inorganic acids include hydrochloric acid, nitric acid, sulfuric acid, hydrofluoric acid, phosphoric acid and boric acid. Examples of the aforementioned organic acids include acetic acid, propionic acid, butanoic acid, pentanoic acid, hexanoic acid, heptanoic acid, octanoic acid, nonanoic acid, decanoic acid, oxalic acid, maleic acid, methylmalonic acid, benzoic acid, p-aminobenzoic acid, p-toluenesulfonic acid, benzenesulfonic acid, trifluoroacetic acid, formic acid, malonic acid, sulfonic acid, phthalic acid, fumaric acid, citric acid, tartaric acid, citraconic acid, malic acid and glutaric acid. Examples of base catalysts include inorganic bases in the manner of alkaline metal hydroxides such as inorganic bases such as lithium hydroxide, sodium hydroxide, potassium hydroxide or cesium hydroxide, alkaline earth metal hydroxides such as calcium hydroxide, strontium hydroxide or barium hydroxide, alkaline or alkaline earth metal carbonates such as lithium carbonate, potassium carbonate or sodium carbonate, and metal bicarbonates such as potassium bicarbonate or sodium bicarbonate. Examples of organic bases include ammonia, trialkylamines such as triethylamine or ethyldiisopropylamine, N,N-dialkylaniline derivatives having 1 to 4 carbon atoms such as N,N-dimethylaniline or N,N-diethylaniline, pyridine, and pyridine derivatives that may or may not have an alkyl substituent having 1 to 4 carbon atoms such as 2,6-lutidine. In addition, examples of metal alkoxides include trimethoxyaluminum, triethoxyaluminum, tri-n-propoxyaluminum, tri-iso-propoxyaluminum, tri-n-butoxyaluminum, tri-iso-butoxyaluminum, tri-sec-butoxyaluminum, tri-tert-butoxyaluminum, trimethoxyboron, triethoxyboron, tri-n-propoxyboron, tri-iso-propoxyboron, tri-n-butoxyboron, tri-iso-butoxyboron, tri-sec-butoxyboron, tri-tert-butoxyboron, tetramethoxysilane, tetraethoxysilane, tetra-n-propoxysilane, tetra-iso-propoxysilane, tetra-n-butoxysilane, tetra-iso-butoxysilane, tetra-sec-butoxysilane, tetra-tert-butoxysilane, tetramethoxygermanium, tetraethoxygermanium, tetra-n-propoxygermanium, tetra-iso-propoxygermanium, tetra-n-butoxygermanium, tetra-iso-butoxygermanium, tetra-sec-butoxygermanium, tetra-tert-butoxygermanium, tetramethoxytitanium, tetraethoxytitanium, tetra-n-propoxytitanium, tetra-iso-propoxytitanium, tetra-n-butoxytitanium, tetra-iso-butoxytitanium, tetra-sec-butoxytitanium, tetra-tert-butoxytitanium, tetramethoxyzirconium, tetraethoxyzirconium, tetra-n-propoxyzirconium, tetra-iso-propoxyzirconium, tetra-n-butoxyzirconium, tetra-iso-butoxyzirconium, tetra-sec-butoxyzirconium and tetra-tert-butoxyzirconium. One type of these catalysts can be used or two or more types can be used as a mixture. In addition, an amount of catalyst used that adjusts the pH of the reaction system during production of the polysiloxane compound (a) to within the range of 0.01 to 6.9 is preferable since the weight average molecular weight of the polysiloxane compound (a) can be favorably controlled. In addition, pH may also be adjusted with acid or base after producing the polysiloxane compound (a).

The condensation reaction for producing the polysiloxane compound (a) can be carried out in an organic solvent. Examples of organic solvents that can be used in the condensation reaction include alcohols, esters, ketones, ethers, aliphatic hydrocarbon compounds, aromatic hydrocarbon compounds and amide compounds.

Examples of the aforementioned alcohols include monovalent alcohols such as methyl alcohol, ethyl alcohol, propyl alcohol or butyl alcohol, polyvalent alcohols such as ethylene glycol, diethylene glycol, propylene glycol, glycerin, trimethylolpropane or hexanetriol, and monoethers of polyvalent alcohols such as ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monomethyl ether, propylene glycol monoethyl ether, propylene glycol monopropyl ether or propylene glycol monobutyl ether.

Examples of the aforementioned esters include methyl acetate, ethyl acetate, butyl acetate and γ-butyrolactone. Examples of ketones include acetone, methyl ethyl ketone and methyl isoamyl ketone.

Examples of the aforementioned ethers include the aforementioned monoethers of polyvalent alcohols as well as polyvalent alcohol ethers obtained by alkyl etherification of all hydroxyl groups of polyvalent alcohols in the manner of ethylene glycol dimethyl ether, ethylene glycol diethyl ether, ethylene glycol dipropyl ether, ethylene glycol dibutyl ether, propylene glycol dimethyl ether, propylene glycol diethyl ether, propylene glycol dipropyl ether, propylene glycol dibutyl ether, diethylene glycol dimethyl ether, diethylene glycol methylether ether or diethylene glycol diethyl ether, tetrahydrofuran, 1,4-dioxane, anisole and propylene glycol monomethyl ether acetate (abbreviated as PGMEA).

Examples of the aforementioned aliphatic hydrocarbon compounds include hexane, heptane, octane, nonane and decane.

Examples of the aforementioned aromatic hydrocarbon compounds include benzene, toluene and xylene.

Examples of the aforementioned amide compounds include dimethylformamide, dimethylacetoamide and N-methylpyrrolidone.

Among the aforementioned solvents, alcohol-based solvents such as methanol, ethanol, isopropanol or butanol, ketone-based solvents such as acetone, methyl ethyl ketone or methyl isobutyl ketone, ether-based solvents such as ethylene glycol monomethyl ether, diethylene glycol monobutyl ether, propylene glycol monomethyl ether, propylene glycol monoethyl ether or PGMEA, as well as dimethylformamide, dimethylacetoamide and N-methylpyrrolidone are preferable since they are readily soluble with water and facilitate dispersion of the silica particles (b) in the polysiloxane compound (a) during the condensation reaction between the polysiloxane compound (a) and the silica particles (b).

These solvents may be used alone or a plurality of solvents may be used in combination. In addition, the reaction may also be carried out in bulk without using the aforementioned solvents.

Although there are no particular restrictions thereon, the reaction temperature during production of the polysiloxane compound (a) is preferably within the range of -50°C to 200°C and more preferably within the range of 0°C to 150°C. By carrying out the reaction within the aforementioned ranges, the molecular weight of the polysiloxane compound (a) can be favorably controlled.

In addition, the polysiloxane compound (a) may also contain an element that forms an oxide such as titanium, zirconium, aluminum, germanium, boron, phosphorous, nitrogen, carbon, gallium or chromium.


[Silica Particles (b)]


The silica particles (b) in the present invention indicate those for which shape and particle diameter thereof can be confirmed with an electron microscope.

Examples of the silica particles (b) used include fumed silica produced using a dry method and colloidal silica produced using a wet method.

The aforementioned fumed silica can be obtained by reacting a compound containing silicon atoms with oxygen and hydrogen in the gaseous phase. Examples of raw material silicon compounds include silicon halides (such as silicon tetrachloride).

Colloidal silica can be synthesized by a sol gel method consisting of hydrolysis and condensation of a raw material compound or by condensation of sodium silicate. Examples of colloidal silica obtained with sol gel methods include that obtained by hydrolytic condensation polymerization using ammonia, an amine catalyst of an alkoxysilane (such as tetramethoxysilane, tetraethoxysilane, methyltrimethoxysilane or phenyltrimethoxysilane) or a halogenated silane compound (such as diphenyldichlorosilane). The alkoxysilane or halogenated silane compound may be respectively be used alone, or a plurality of compounds may be used as a mixture. In particular, those having low levels of impurities such as metals or halogens are preferable, and colloidal silica produced by a wet method from an alkoxysilane such as tetramethoxysilane or tetraethoxysilane is more preferable from the viewpoint of having a small coefficient of linear thermal expansion.

The range of mean primary particle diameter over which the silica particles can be used is preferably 1 nm to 100 nm, more preferably 1 nm to 20 nm and even more preferably 2 nm to 15 nm. The aforementioned mean primary particle diameter is preferably 1 nm or more since hardness of a cured product improves, and in the case of being 100 nm or less, transparency improves, thereby making this preferable.

The mean secondary particle diameter of the silica particles is preferably 2 nm to 250 nm and more preferably 2 nm to 80 nm. In the case the aforementioned mean secondary particle diameter is 2 nm or more, hardness improves thereby making this preferable, while in the case the mean secondary particle diameter is 250 nm or less, transparency of a cured product improves in the wavelength region of 300 nm or less, thereby making this preferable.

The aforementioned mean primary particle diameter is a value determined by calculating from BET specific surface area and/or a value determined by observing with a scanning electron microscope, while the mean secondary particle diameter is a value measured with a dynamic light scattering spectrophotometer.

Although the shape of the silica particles (b) can be spherical, rod-shaped, plate-shaped, filamentous or a combination of two or more types thereof, the silica particles (b) are preferably spherical. Furthermore, spherical as referred to here includes being perfectly spherical as well as being roughly spherical such as being in the shape of an oblate spheroid or ovate spheroid.

The specific surface area of the silica particles (b) is preferably 25 $m^2$/g to 1400 $m^2$/g and more preferably 35 $m^2$/g to 1400 $m^2$/g in terms of BET specific surface area from the viewpoints of viscosity of the condensation reaction product of the polysiloxane compound (a) and the silica particles (b) and the hardness of a cured product. The aforementioned BET specific surface area refers to a value measured using a method in which it is calculated from the pressure of $N_2$ molecules and the amount of gas adsorbed.

In addition, the silica particles (b) may also contain an element that forms an oxide such as titanium, zirconium, aluminum, germanium, boron, phosphorous, nitrogen, carbon, gallium or chromium.

The silica particles (b) used in the present invention must have silanol groups and/or alkoxy groups on the surface thereof in order to condense with the polysiloxane compound (a) and/or a silane compound represented by the aforementioned general formula. The silica particles (b) may be modified with other organic groups provided they have silanol groups and/or alkoxy groups.

The number of silanol groups on the surface of the silica particles (b) is preferably 0.5 groups/$nm^2$ to 15 groups/$nm^2$ and more preferably 1 group/$nm^2$ to 3 groups/$nm^2$, and from the viewpoint of reactivity, preferably 0.5 groups/$nm^2$ or more, while from the viewpoint of lowering water adsorption of a cured molded product, preferably 15 groups/$nm^2$ or less. The ratio of silanol groups can be determined by $^{29}$Si-NMR, for example, by adding a relaxation enhancement agent to an aqueous solution or organic solution.

Examples of solvents that disperse the silica particles (b) include water, alcohol-based solvents such as methanol, ethanol, isopropanol or butanol, ketone-based solvents such as acetone, methyl ethyl ketone and methyl isobutyl ketone, ether-based solvents such as ethylene glycol monomethyl ether, diethylene glycol monobutyl ether, propylene glycol monomethyl ether, propylene glycol monoethyl ether or PGMEA, dimethylformamide, dimethylacetoamide and N-methylpyrrolidone. These solvents are preferable since they facilitate dispersion of the silica particles (b) having silanol groups, and these solvents may also be used as a mixture. The type of dispersing solvent used varies according to the surface modifying groups of the silica particles (b) used.

Although silica particles that satisfy the aforementioned requirements can be preferably used for the silica particles (b), there are no restrictions thereon and commercially available products can also be used.

Examples of colloidal silica commercially available products include members of the Levasil series (H.C. Starck GmbH), Methanol Silica Sol IPA-ST, Methanol Silica Sol NBA-ST, Methanol Silica Sol XBA-ST, Methanol Silica Sol DMAC-ST, Methanol Silica Sol ST-UP, Methanol Silica Sol ST-OUP, Methanol Silica Sol ST-20, Methanol Silica Sol ST-40, Methanol Silica Sol ST-C, Methanol Silica Sol ST-N, Methanol Silica Sol ST-O, Methanol Silica Sol ST-50 or Methanol Silica Sol ST-OL (Nissan Chemical Industries Co., Ltd.), members of the Quatron PL series (Fuso Chemical Co., Ltd.) and members of the Oscal series (Nippon Shokubai Kagaku Kogyo Co., Ltd.), examples of powdered silica particles include Aerosil 130, Aerosil 300, Aerosil 380, Aerosil TT600 or Aerosil OX50 (Nippon Aerosil Co., Ltd.), Sildex H31, Sildex H32, Sildex H51, Sildex H52, Sildex H121 or Sildex H122 (Asahi Glass Co., Ltd.), E220 or E220 (Nippon Silica Co., Ltd.), Sylysia A470 (Fuji Sylysia Chemical Ltd.) and SG Flakes (Nippon Sheet Glass Co., Ltd.), and examples of powdered silica particles include Aerosil 130, Aerosil 130, Aerosil 300, Aerosil 380, Aerosil TT600 or Aerosil OX50 (Nippon Aerosil Co., Ltd.), Sildex H31, Sildex H32, Sildex H51, Sildex H52, Sildex H121 or Sildex H122 (Asahi Glass Co., Ltd.), E220 or E220 (Nippon Silica Co., Ltd.), Sylysia A470 (Fuji Sylysia Chemical Ltd.) and SG Flakes (Nippon Sheet Glass Co., Ltd.).

<Production of Silica Particle-Containing Condensation

Reaction Product (A)>

The silica particle-containing condensation reaction product (A) of the present invention is obtained by reacting the polysiloxane compound (a) and/or a silane compound represented by the aforementioned general formula (1) with the silica particles (b). Although the reaction between the polysiloxane compound (a) and/or a silane compound represented by the aforementioned general formula (1) and the silica particles (b) may be an interaction in the manner of hydrogen bonding or covalent bonding, it is preferably covalent bonding by a condensation reaction from the viewpoint of crack resistance of a cured molded product.

During the condensation reaction, the silica particles (b) can be reacted with the polysiloxane compound (a) and/or a silane compound represented by the aforementioned general formula (1) while dispersed in a solvent. Water, an organic solvent or a mixed solvent thereof can be used for the solvent. The type of organic solvent used varies according to the dispersion medium of the silica particles (b) used. In the case the dispersion medium of the silica particles (b) used is an aqueous dispersion medium, the silica particles (b) may be reacted with the polysiloxane compound (a) or a silane compound represented by the aforementioned general formula (1) after adding water and/or alcohol-based solvent to the aqueous dispersion medium of the silica particles (b), or the silica particles (b) may be reacted with the polysiloxane compound (a) or a silane compound represented by the aforementioned general formula (1) after replacing the solvent of an aqueous solution of the silica particles (b) with an alcohol-based solvent.

Although the silica particle-containing condensation reaction product (A) is obtained by reacting the silicon particles (b) with the polysiloxane compound (a), the silica particles (b) with the polysiloxane compound (a) and a silane compound represented by the aforementioned general formula (1), or the silica particles (b) with a silane compound represented by the aforementioned general formula (1), from the viewpoint of crack resistance of a cured molded product, the silica particle-containing condensation reaction product (A) is preferably obtained by reacting the silica particles (b) with a compound that contains the polysiloxane compound (a).

Examples of solvents used during the condensation reaction between the polysiloxane compound (a) and/or a silane compound represented by the aforementioned general formula (1) and the silica particles (b), and examples of alcohol-based solvents able to be used as a replacement solvent of the silica particles include methanol, ethanol, n-propanol, 2-propanol, n-butanol, methoxyethanol and ethoxyethanol, and these are preferable since they are readily miscible with water.

In the case the dispersion medium of the silica particles (b) used is a solvent such as an alcohol, ketone, ester or hydrocarbon, a solvent such as water, alcohol, ether, ketone or ester can be used. Examples of alcohols include methanol, ethanol, n-propanol, 2-propanol and n-butanol. Examples of ether solvents include dimethoxyethane and PGMEA. Examples of ketone solvents include acetone, methyl ethyl ketone and methyl isobutyl ketone. Examples of ester solvents include methyl acetate, ethyl acetate, propyl acetate, ethyl formate, propyl formate and γ-butyrolactone. Examples of hydrocarbon solvents include hexane, heptane, octane, nonane, decane, benzene, toluene and xylene.

The condensation reaction between the silica particles (b) and the polysiloxane compound (a) may be carried out in an acidic atmosphere or basic atmosphere. The pH range is preferably 3 to 10 and more preferably 5 to 9. If the condensation reaction is carried out within the aforementioned ranges, the condensation reaction is able to proceed without the occurrence of gelling or clouding, thereby making this preferable. A catalyst may be used during the condensation reaction, and examples of acid catalysts, base catalysts and metal alkoxides able to be used are the same as those listed as examples of catalysts used during production of the polysiloxane compound (a), and although the catalyst may be removed following production of the polysiloxane compound (a), in the case of reacting the silica particles (b) as is without removing the catalyst following production of the polysiloxane compound (a), the reaction between the polysiloxane compound (a) and the silica particles (b) can be carried out with the catalyst used when reacting the polysiloxane compound (a) without having to additionally add catalyst. In addition, catalyst may also be additionally added during reaction of the polysiloxane compound (a) and the silica particles (b).

In addition, in the case of having added an acid catalyst during production of the polysiloxane compound (a), the condensation reaction may be carried out by shifting towards the neutral or basic side by adding a base catalyst to the polysiloxane compound (a) when reacting the silica particles (b) and the polysiloxane compound (a).

Although there are no particular restrictions on the reaction temperature when producing the condensation reaction product of the polysiloxane compound (a) and the silica particles (b), it is preferably within the range of -50°C to 200°C and more preferably within the range of 0°C to 150°C. By carrying out the reaction within the aforementioned ranges, the condensation ratio between the polysiloxane compound (a) and the silica particles (b) (polysiloxane-silica condensation ratio) can be controlled.

Water used during the condensation reaction of the polysiloxane compound (a) and the silica particles (b) is preferably removed by a method such as distillation after having added a solvent selected from the aforementioned solvents to reduce the amount of water and/or alcohol in the reaction condensation product to 1% by weight or less. If the content of water and/or alcohol is within the aforementioned range, cure shrinkage is reduced and it becomes difficult to form cracks when curing the photosensitive silicone resin composition of the present invention, thereby making this preferable.

The pH of the silica particle-containing condensation reaction product (A) is preferably adjusted to 6 to 8 by removing the catalyst by a method such as distillation, washing by extraction or ion exchange either after the condensation reaction when synthesizing the polysiloxane compound (a) or after the condensation reaction of the polysiloxane compound (a) and the silica particles (b). If the pH is within the aforementioned range, the pot life of the silica particle-containing condensation reaction product (A) can be extended.

The silica particle-containing condensation reaction product of the present invention is such that the terminal structure Si-O-Y (wherein, Y represents $R^2$ or $SiR^3_3$, $R^2$ and $R^3$ represent hydrogen atoms or organic groups having 1 to 20 carbon atoms, and the plurality of $R^3$ may each be the same or different) satisfies the following formula (2):

$$0 < [\text{Si-O-SiR}^3_3]/([\text{Si-O-R}^2] + [\text{Si-O-SiR}^3_2]) \leq 1 \qquad (2)$$

(wherein, $R^2$ and $R^3$ are as previously described).

$R^2$ and/or $R^3$ are hydrogen atoms or organic groups having 1 to 20 carbon atoms.

A terminal structure Si-O-$R^2$ can have an Si-O bond or have an Si-O-Si bond by a polycondensation reaction with another molecule.

In the present description, the term "terminal structure Si-O-Y" does not include a structure (Si-Y) (wherein, represents $R^2$ or $SiR^3_3$, $R^2$ and $R^3$ represent hydrogen atoms or organic groups having 1 to 20 carbon atoms, and the plurality of $R^3$ may each be the same or different) in which the silicon atom is not bonded to an oxygen atom. Furthermore, the silica particle-containing condensation reaction product (A) of the present invention may contain a terminal structure other than the "terminal structure Si-O-Y".

In addition, the [Si-O-SiR$^3_3$] and [Si-O-R$^2$] in formula (2) are defined in the manner described below.

In the present description, a component in which the number of Si atoms contained in the silica particle-containing condensation reaction product (A) bonded to the O atom is one is referred to as "component M", a component in which the number of Si atoms bonded to the O atom is two is referred to as "component D", a component in which the number of Si atoms bonded to the O atom is three is referred to as "component T", and a component in which the number of Si atoms bonded to the O atom is four is referred to as "component Q". Moreover, a component M in which the single Si-O bond present is an Si-O-Si bond is referred to as "component M1", while a component M that does not have an Si-O-Si bond is referred to as "component M0", a component D that does not have an Si-O-Si bond among the two Si-O bonds present is referred to as "component D0", a component D in which one of the Si-O bonds is an Si-O-Si bond is referred to as "component D1", and a component D in which both of the Si-O bonds are Si-O-Si bonds is referred to as "component D2", a component T that does not have an Si-O-Si bond among the three Si-O bonds present is referred to as a "component T0", a component T in which one of the Si-O bonds is an Si-O-Si bond is referred to as "component T1", a component T in which two of the Si-O bonds are Si-O-Si bonds is referred to as "component T2", and a component T in which all three of the Si-O bonds are Si-O-Si bonds is referred to as "component T3", and a component Q that does not have an Si-O-Si bond among the four Si-O bonds present is referred to as "component Q0", a component Q in which one of the Si-O bonds is an Si-O-Si bond is referred to as "component Q1", a component Q in which two of the Si-O bonds are Si-O-Si bonds is referred to as "component Q2", a component Q in which three of the Si-O bonds are Si-O-Si bonds is referred to as "component Q3", and a component Q in which all four of the Si-O bonds are Si-O-Si bonds is referred to as "component Q4".

The value of each component in the silica particle-containing condensation reaction product (A) can be measured or calculated by $^{29}$Si-NMR, and when the peak area of component M1 as measured by $^{29}$Si-NMR is represented as (M1), then the [Si-O-SiR$^3_3$] in the aforementioned formula (2) is represented as (M1) and [Si-O-R$^2$] is represented as the sum of twice the amounts of (D1) and (T1), three times the amounts of (T2) and (Q1), twice the amount of (Q2) and (Q3). The value of [Si-O-SiR$^3_3$]/([Si-O-R$^2$] + [Si-O-SiR$^3_3$]) is preferably greater than 0 and less than or equal to 1, more preferably greater than 0.15 and less than or equal to 1, and even more preferably greater than 0.3 and less than or equal to 1. Since the number of radical groups in the photosensitive silicone resin composition decreases if the value of [Si-O-SiR$^3_3$]/([Si-O-R$^2$] + [Si-O-SiR$^3_3$]) is greater than 0, a cured molded product can be obtained that has low thermal weight loss during heating as well as low water absorption.

[Silicon Compound (c)]

The silica particle-containing condensation reaction product (A) has an [Si-O-SiR$^3_3$] structure derived from component M1. The [Si-O-SiR$^3_3$] structure derived from component M1 may be contained in the polysiloxane compound (a), can be obtained by simultaneously reacting a silicon compound (c) represented by the following general formula (1) and/or general formulas (3) to (8) when reacting the polysiloxane compound (a) and the silica particles (b), or can be obtained by further reacting following reaction of the polysiloxane compound (a) and the silica particles (b).

Although there are no particular limitations on examples of the silicon compound (c) serving as component M1 provided it is able to form Si-O-Si bonds by reacting with silanol groups or alkoxy groups, examples thereof include silane compounds represented by general formula (1) :

$$R^1_{n1}SiX^1_{4-n1} \qquad (1)$$

(wherein, $R^1$ represents a hydrogen atom or organic group containing 1 to 20 carbon atoms, n1 represents an integer of 0 to 3, $X^1$ represents a group selected from the group consisting of a hydroxyl group, halogen atom, alkoxy group having 1 to 6 carbon atoms and acetoxy group having 1 to 6 carbon atoms, and n1, $R^1$ and $X^1$ may each be the same or different in the case a plurality thereof is present) in which n1 is 3, disilazane compounds represented by the following general formula (4):

$$R^5_3SiNHSiR^6_3 \qquad (4)$$

(wherein, $R^5$ and $R^6$ represent hydrogen atoms or organic groups having 1 to 10 carbon atoms, and $R^5$ and $R^6$ may each be the same or different in the case a plurality thereof are present), silane compounds represented by the following general formula (5):

$$R^7_3SiH \qquad (5)$$

(wherein, $R^7$ represents a hydrogen atom or organic group having 1 to 10 carbon atoms, and the plurality of $R^7$ present may be the same or different), disilane compounds represented by the following general formula (6):

$$R^8_3SiSiR^8_3 \qquad (6)$$

(wherein, $R^8$ represents a hydrogen atom or organic group having 1 to 10 carbon atoms, and the plurality of $R^8$ present may be the same or different), urea compounds represented by the following general formula (7):

$$R^9_3SiNHCONHSiR^9_3 \qquad (7)$$

(wherein, $R^9$ represents a hydrogen atom or organic group having 1 to 10 carbon atoms, and the plurality of $R^9$ present may be the same or different), disiloxane compounds represented by the following general formula (8) :

$$R^9_3SiOSiR^9_3 \qquad (8)$$

(wherein, $R^9$ represents a hydrogen atom or organic group having 1 to 10 carbon atoms, and the plurality of $R^9$ present may be the same or different), N,O-bis(trimethylsilyl) trifluoroacetoamide and trimethylsilyltrifluoro- methanesulfonate, and the polysiloxane compound (a) and/or a silane compound represented by the aforementioned general formula (1) and the silica particles (b) are condensed by including these components M1.

Moreover, from the viewpoints of reactivity and crack resistance, among those compounds represented by the aforementioned general formula (1), component M1 is preferably one or types of the silicon compound (c) represented by the following general formula (3), in which $R^1$ is a hydrogen atom or organic group having 1 to 10 carbon atoms and n1 is 3:

$$R^4_3SiX^2 \qquad (3)$$

(wherein, $R^4$ represents a hydrogen atom or an organic group having 1 to 10 carbon atoms, $X^2$ represents a group selected from the group consisting of a hydroxyl group, halogen atom, alkoxy group having 1 to 6 carbon atoms and acetoxy group having 1 to 6 carbon atoms, and $R^4$ may be the same or different in the case a plurality thereof are present), or the following general formula (4):

$$R^5_3SiNHSiR^6_3 \qquad (4)$$

(wherein, $R^5$ and $R^6$ represent a hydrogen atom or an organic group having 1 to 10 carbon atoms, and $R^5$ and $R^6$ may be the same or different in the case a plurality thereof is present).

One type of the silicon compound (c) can be used or two or more types can be used in combination. In addition, the aforementioned silicon compound (c) may be added undiluted or may be added after diluting in a solvent not having an active hydrogen to be subsequently described. In the case of using a combination of two or more types, the two or more types of silicon compounds (c) may be added all at once or added incrementally during production.

$R^4$ in the aforementioned general formula (3) represents a hydrogen atom or organic group having 1 to 10 carbon atoms, and specific examples thereof include organic groups listed as examples of $R^1$. In particular, from the viewpoint of heat resistance, $R^4$ is preferably a hydrogen atom, vinyl group, methyl group, ethyl group, phenyl group, acryloxymethyl group, acryloxyethyl group, acryloxypropyl group, methacryloxymethyl group, methacryloxyethyl group, methacryloxypropyl group, styryl group or norborneyl group.

$X^2$ in the aforementioned general formula (3) represents a hydroxyl group or hydrolyzable substituent, examples thereof include substituents previously listed as examples of $X^1$, and in particular, from the viewpoint of ease of forming a Si-O-Si bond, is preferably a halogen atom such as chlorine, bromine or iodine, an alkoxy group such as a methoxy group, or an acetoxy group.

In a compound of general formula (3) used for the silicon compound (c), $X^2$ is preferably a halogen atom and more preferably a Cl atom from the viewpoint of reactivity with silanols.

Specific examples of silane halides in which $X^2$ is a Cl atom include alkylchlorosilanes such as trimethylchlorosilane, dimethylchlorosilane, methyltrichlorosilane or dimethylchlorosilane, unsaturated hydrocarbon group-containing chlorosilanes such as dimethylvinylchlorosilane, aromatic group-containing chlorosilanes such as triphenylchlorosilane, diphenylchlorosilane or dimethylphenylchlorosilane, aliphatic group-containing chlorosilanes such as dimethylcyclohexylchlorosilane, dicyclohexylmethylchlorosilane, dimethylcyclopentylchlorosilane or dicyclopentylmethylchlorosilane, and chlorosilanes having a radical polymerizable unsaturated carbon double bond such as acryloxypropyldimethylchlorosilane, methacryloxypropyldimethylchlorosilane or styryldimethylchlorosilane.

$R^5$ and $R^6$ in general formula (4) represent a hydrogen atom or organic group having 1 to 10 carbon atoms, and specific examples thereof include the organic groups listed as examples of $R^1$. In particular, from the viewpoint of heat resistance, $R^5$ and $R^6$ are preferably methyl groups, ethyl groups, cyclohexyl groups or phenyl groups.

Specific examples of silylamines represented by general formula (4) include hexamethyldisilazane, tetramethyldisilazane, divinyltetramethyldisilazane, lithium hexamethyldisilazane, sodium hexamethyldisilazane, sodium divinyltetramethyldisilazane, potassium hexamethyldisilazane, potassium tetramethyldisilazane and potassium divinyltetramethyldisilazane.

The amount of the silicon compound (c) used in terms of the molar equivalent is preferably 0.1 times to 10 times, more preferably 0.5 times to 5 times, even more preferably 0.7 times to 2 times, and most preferably 0.7 times to 1.5 times the silanol content of the polysiloxane compound (a) and/or silane compound represented by the aforementioned general formula (1) other than the silicon compound (c) (in the case of also reacting the silicon compound (c) during condensation of the polysiloxane compound (a) and the silica particles (b)), or the silanol content of the condensation product of the polysiloxane compound (a) and/or a silane compound represented by the aforementioned general formula (1), other than the silicon compound (c), and the silica particles (b) (in the case of further reacting the silicon compound with the condensation reaction product). From the viewpoint of heat resistance, the aforementioned amount used is preferably 0.1 times or more, and from the viewpoint of yield, is preferably 10 times or less. Furthermore, the aforementioned silanol content can be measured according to the method described below. Namely, after calculating the hydrolysis ratio by gas chromatography analysis, the condensation ratio is calculated by $^{29}$Si-NMR to calculate the amount of silanol contained in the polysiloxane compound (a) or in the condensation reaction product of the polysiloxane compound (a) and the silica particles (b).

In obtaining the silica particle-containing condensation reaction product (A), the polysiloxane compound (a) and/or a silane compound represented by the aforementioned general formula (1) and the silica particles (b) may be condensed by a one-pot reaction, the silica particles (b) may be condensed after producing the polysiloxane compound (a), or the silica particles (b) may be condensed after producing the polysiloxane compound (a), followed by further condensing the polysiloxane compound (a) and/or a silane compound represented by the aforementioned general formula (1).

In addition, when further condensing the silicon compound (c), although the polysiloxane compound (a) and/or a silane compound represented by the aforementioned general formula (1), the silica particles (b) and the silicon compound (c) may be condensed simultaneously, the silicon compound (c) may be simultaneously condensed during the hydrolytic condensation reaction of the polysiloxane compound (a) and/or a silane compound represented by the aforementioned general formula (1) followed by condensing the silica particles (b), the silica particles (b) may be reacted after obtaining the polysiloxane compound (a) and reacting with the silicon compound (c), the silica particles (b) and the silicon compound (c) may be reacted first followed by reacting the polysiloxane compound (a) and/or a silane compound represented by the aforementioned general formula (1), or the silicon compound (c) may be reacted after obtaining the condensation reaction product of the polysiloxane compound (a) and/or a silane compound represented by the aforementioned general formula (1) and the silica particles (b), from the viewpoint of reactivity, the silicon compound (c) is preferably reacted after obtaining the condensation reaction product of the polysiloxane compound (a) and/or a silane compound represented by the aforementioned general formula (1) and the silica particles (b).

In the case the silicon compound (c) is an alkoxysilane, the silicon compound can be condensed and reacted using a method similar to the method used to react the aforementioned polysiloxane compound (a) and the silica particles (b).

In the case the silicon compound (c) has high reactivity with active hydrogen in the manner of a silane halide or disilazane derivative and the like, reaction of the silicon compound is preferably carried out in a solvent such as water or alcohol that does not have an active hydrogen. Preferable examples of solvents include esters, ketones, ethers, aliphatic hydrocarbon compounds, aromatic hydrocarbon compounds and amide compounds.

Examples of the aforementioned esters include methyl acetate, ethyl acetate, butyl acetate and $\gamma$-butyrolactone. Examples of ketones include acetone, methyl ethyl ketone and methyl isoamyl ketone.

Examples of the aforementioned ethers include polyvalent alcohol ethers obtained by alkyl etherification of all hydroxyl groups of polyvalent alcohols and polyvalent alcohol esters obtained by alkyl etherification and/or etherification of all hydroxyl groups of polyvalent alcohols in the manner of ethylene glycol dimethyl ether, ethylene glycol diethyl ether, ethylene glycol dipropyl ether, ethylene glycol dibutyl ether, propylene glycol dimethyl ether, propylene glycol diethyl ether, propylene glycol dibutyl ether, diethylene glycol dimethyl ether, diethylene glycol methylethyl ether, diethylene glycol diethyl ether, as well as tetrahydrofuran, 1,4-dioxane, anisole and PGMEA.

Examples of the aforementioned aliphatic hydrocarbon compounds include hexane, heptane, octane, nonane and decane.

Examples of the aforementioned aromatic hydrocarbon compounds include benzene, toluene and xylene.

Examples of the aforementioned amide compounds include dimethylformamide, dimethylacetoamide and N-methylpyrrolidone.

These solvents may be used alone or a plurality of types thereof may be used in combination. In addition, the reaction may be carried out in bulk without using the aforementioned solvents.

In addition, the reaction can be carried out using a solvent similar to that used with the silicon compound (c) when reacting a silane halide other than the silicon compound (c), and more specifically, a silane compound in which n1 in the aforementioned general formula (1) is 1 or 2.

The reaction is preferably carried out such that the water content in the reaction system is 0.0001% by weight to 5% by weight from the viewpoints of reducing the formation of polymers by low molecular weight components and obtaining a resin having favorable heat resistance.

An organic base is preferably used as a catalyst or silicon compound scavenger in the reaction when using a compound represented by the aforementioned general formula (3) for the silicon compound (c) from the viewpoint of condensation rate.

Examples of organic bases include pyridine, pyrrole, piperazine, pyrrolidine, picoline, monoethanolamine, diethanolamine, dimethylmonoethanolamine, monomethyldiethanolamine, triethanolamine, diazabicyclooctane, diazabicycloundecene, tetramethylammonium hydroxide, tetraethylammonium hydroxide, tetrapropylammonium hydroxide, tetrabutylammonium hydroxide, ammonia, methylamine, ethylamine, propylamine, butylamine, N,N-dimethylamine, N, N-diethylamine, N,N-dipropylamine, N,N-dibutylamine, trimethylamine, triethylamine, tripropylamine and tributylamine. One type of these organic bases can be used alone or two or more types can be used as a mixture.

The amount of organic base used varies according to the type of the silicon compound (c), and in the case the silicon compound (c) is a silane halide, an amount equal to 0.1 times to 20 times the equivalent of the silicon compound is preferable from the viewpoint of facilitating progression of the silylation reaction, while an amount equal to 0.5 to 10 times the equivalent of the silicon compound is more preferable. The organic base results in the formation of a by-product salt by functioning as a scavenger of silane halides.

An organic base similar to that used with the silicon compound (c) can also be used and reacted when reacting a silane halide other than the silicon compound (c), and more specifically, a silane compound in which n1 of the aforementioned general formula (1) is 1 or 2, the amount of organic base used in this case is preferably 0.1 times to 20 times the equivalent of halogen in the silane compound from the viewpoint of facilitating progression of the silylation reaction, and the amount of organic base is more preferably 0.5 times to 10 times the equivalent of halogen in the silane compound.

In the case the silicon compound (c) is an alkoxysilane, the amount of the silicon compound (c) used is preferably 0.001 equivalents to 2 equivalents of the organic base.

Although there are no particular restrictions thereon, the reaction temperature when using a compound represented by the aforementioned general formula (3) for the silicon compound (c) is preferably within the range of -78°C to 200°C and more preferably within the range of -20°C to 150°C.

Following the reaction when using a compound represented by general formula (3) for the silicon compound (c), the hydrochloride formed and organic base present in the reaction system are preferably removed and purified by a method such as rinsing with water, extraction, precipitation, ion exchange or filtration. The pH of the silica particle-containing condensation reaction product of the present invention is preferably adjusted to 6 to 8 with these methods. If the pH is within the aforementioned range, the pot life of the condensation reaction product of the present invention is extended, thereby making this preferable.

In addition, reaction temperature and organic base removal and purification steps similar to those used for the silicon compound (c) can also be used when reacting a silane halide other than the silicon compound (c), and more specifically, a silane compound in which n1 of the aforementioned general formula (1) is 1 or 2.

When using a compound represented by general formula (4) for the silicon compound (c), the reaction in the case an organic base is formed may be carried out by bubbling using an inert gas in order to remove the formed organic base from the system from the viewpoint of condensation rate and controlling the pH of the system. Following the reaction, the hydrochloride formed, metal amide and organic base present in the reaction system are preferably removed and purified by a method such as rinsing with water, extraction, precipitation, ion exchange or filtration. The pH of the silica particle-containing condensation reaction product of the present invention is preferably adjusted to 6 to 8 with these methods. If the pH is within the aforementioned range, the pot life of the condensation reaction product of the present invention is extended, thereby making this preferable.

Although there are no particular restrictions thereon, the reaction temperature when using a compound represented by general formula (4) for the silicon compound (c) is preferably within the range of -78°C to 200°C and more preferably within the range of -20°C to 150°C.

When purifying the silica particle-containing condensation reaction product, water in the system is preferably removed by a method such as liquid separation after having added a solvent selected from the aforementioned solvents or distillation.

The amount of water contained in the silica particle- containing condensation reaction product is preferably 1% by weight or less. In this case, there is little weight loss, cure shrinkage is reduced and there is less susceptibility to crack formation when curing the condensation reaction product, thereby making this preferable. The water content can be measured by a method such as gas chromatography or the Karl Fischer method.

In addition, the amount of solvent contained in the silica particle-containing condensation reaction product is preferably 1% by weight or less. In this case, there is little weight loss, cure shrinkage is reduced and there is less susceptibility to crack formation when curing the photosensitive silicone resin composition, thereby making this preferable. The solvent content can be measured using a method such as gas chromatography.

The silica particle-containing condensation reaction product (A) of the present invention is obtained by a condensation reaction of a reactive component at least containing the polysiloxane compound (a) and/or a silane compound represented by general formula (1) and the silica particles (b).

In the present description, a "reactive component" refers to a component that forms a condensed structure in the silica particle-containing condensation reaction product. The content of the silica particles (b) in the reactive component is preferably 1% by weight to 80% by weight. The aforementioned content is preferably 1% or more from the viewpoint of improving the hardness of a cured film, and is preferably 80% by weight or less from the viewpoint of the viscosity of the condensation reaction product. The aforementioned content is more preferably 10% by weight to 70% by weight and even more preferably 20% by weight to 60% by weight. The content of the silica particles (b) is expressed as a weight percentage of the reactive component of the silica particles (b) in the silica particle-containing condensation reaction product (A) and the silica particles (b), and the weight percentage of the reactive component of the silica particles (b) is calculated from the weight of the silica particles (b) used in the reaction. Reactive components other than the silica particles (b) include the polysiloxane compound (a) and/or a silane compound represented by general formula (1) and the silicon compound (c), and the content thereof is preferably 20% by weight to 99% by weight.

Reactive components of the silica particle-containing condensation reaction product (A) other than the silica particles (b) can be calculated as a molar ratio of raw materials used in the reaction or as a molar percentage from $^1$H-NMR and $^{29}$Si-NMR measurements based on a value of 100 mol% for the reactive components other than the silica particles (b). The molar ratios of the component D, component T and component Q used in the reaction can be calculated from the raw materials used, and the molar ratio of component M can be calculated from the area ratio of $^{29}$Si-NMR measurement and the area ratio of specific functional groups observed in $^1$H-NMR. The molar ratio {component M/ (component M + component D + component T + component Q)} x 100 of component M to the total number of moles of component M, component D, component T and component Q in the portion of the silica particle-containing condensation reaction product (A) excluding the silica particles (b) is preferably 1 mol% to 50 mol%. Making this ratio to be 50 mol% or less is preferable from the viewpoint of reactivity, while making this ratio to be 1 mol% or more is preferable from the viewpoints of the pot life of the silica particle-containing condensation reaction product (A).

In the present invention, the condensation reaction product condensation ratio, which is defined as the ratio of the number of bonds that form siloxane bonds to the total number of bonds that respectively form siloxane bonds, direct bonds with hydroxyl groups and direct bonds with the aforementioned hydrolyzable groups in the condensation reaction product, is preferably 40 mol% to 100 mol%, more preferably 50 mol% to 100 mol%, and even more preferably 60 mol% to 100 mol% from the viewpoint of favorably obtaining the effects of increased hardness and reduced tackiness due to the formation of a condensed structure.

The aforementioned condensation ratio of the condensation reaction product can be calculated by confirming components M0, M1, D0, D1, D2, T0, T1, T2, T3, Q0, Q1, Q2, Q3 and Q4 by analyzing by $^{29}$Si-NMR.

The condensation ratio of the silica particle-containing condensation reaction product can be calculated in the manner indicated below from the area ratio of each silicon peak in $^{29}$Si-NMR.

For example, the peak area of component D1 is expressed as (D1).

The condensed silicon area becomes:

$$\{(M1)+ (D1) + (D2) \times 2 + (T1) + (T2) \times 2 + (T3) \times 3 + (Q1) + (Q2) \times 2 + (Q3) \times 3 + (Q4) \times 4\},$$

and the total silicon area becomes:

$$\{(MO) + (M1)\} + \{(D0) + (D1) + (D2)\} \times 2 + \{(T0) + (T1) + (T2) + (T3)\} \times 3 + \{(Q0) + (Q1) + (Q2) + (Q3) + (Q4)\} \times 4,$$

and

$$\text{condensation ratio} = (\text{condensed silicon area})/(\text{total silicon area}) \times 100$$

The weight average molecular weight of the silica particle- containing condensation reaction product (A) is preferably within the range of 1,000 to 200,000 and more preferably within the range of 1,000 to 100,000. Weight average molecular weight can be determined by, for example, gel permeation chromatography (GPC) using polymethacrylate for the standard. In the case the weight average molecular weight of the condensation reaction product is 1,000 or more, the heat resistance of a cured product increases and pot life of the silica particle-containing condensation reaction product (A) becomes longer, while in the case the weight average molecular weight is 200,000 or less, mold filling improves and shape transferability improves since the viscosity of the silica particle-containing condensation reaction product (A) can be lowered.

The silica particle-containing condensation reaction product (A) has a photopolymerizable functional group. A photopolymerizable functional group in the present description refers to a functional group that can be polymerized by irradiating with light, and includes that for which a polymerization reaction due to irradiation with light occurs with a single type of functional group, or that for which polymerization only occurs with a combination of two or more types of functional groups, in the presence of the photopolymerization initiator (B). Examples of types of photopolymerization include radical polymerization, cationic polymerization and an addition reaction by an ene-thiol reaction.

Examples of photopolymerizable functional groups include a (meth)acryloyl group, epoxy group, glycidyl group, oxetane, vinyl ether, mercapto group, styryl group, norborneyl group, vinyl group, allyl group and other groups having an unsaturated carbon bond, and hydrogen groups of these various hydrocarbon groups or a portion of the main chain skeleton may be partially substituted with substituents selected from polar groups (polar bonds), such as a hydrocarbon group, ether bond, ester group (bond), hydroxyl group, thioether group, carbonyl group, carboxyl group, carboxylic anhydride bond, thioether bond, sulfone group, aldehyde group, epoxy group, amino group, substituted amino group, amido group (bond) imido group (bond), imino group, urea group (bond), urethane group (bond), isocyanate group or cyano group, or a halogen atom such as a fluorine atom, chlorine atom or bromine atom.

In particular, the photopolymerizable functional group in the silica particle-containing condensation reaction product (A) is preferably a (meth)acryloyl group, styryl group, norborneyl group, epoxy group or mercapto group from the viewpoint of reactivity during synthesis of the silica particle-containing condensation reaction product (A), more preferably a (meth) acryloyl group and/or styryl group from the viewpoint of curability, and even more preferably an epoxy group and/or mercapto group from the viewpoint of cure shrinkage.

In the present invention, although a photopolymerizable functional group may modify the surface of the silica particles (b) in the condensation reaction and the like, from the viewpoint of crack resistance, the polysiloxane compound (a) and/or the silicon compound (c) preferably contain photopolymerizable functional groups.

In particular, at least either of a silane compound represented by the aforementioned general formula (1) or a condensation product thereof and the silicon compound (c) represented by the aforementioned general formula (2) or the aforementioned general formula (3) preferably contain radical polymerizable unsaturated carbon double bond groups, and the ratio of silicon atoms to which the radical polymerizable unsaturated carbon double bond groups are bonded is preferably 5 mol% to 80 mol%, more preferably 10 mol% to 70 mol%, and even more preferably 15 mol% to 50 mol% of all silicon atoms contained in these components. As a result of making the aforementioned ratio to be 5 mol% or more, the cured product can be made to have high hardness, and as a result of making the aforementioned ratio to be 80 mol% or less, the cured product can be made to have high heat resistance, high light resistance and low cure shrinkage.

The aforementioned ratio can be calculated from the molar ratio of reactive components of the silica particle-containing condensation reaction product (A), or can be calculated from the molar ratio of raw materials used in the reaction and $^1$H-NMR analysis and $^{29}$Si-NMR analysis in a solution or solid.

[Photopolymerization Initiator (B)]

The photopolymerization initiator (B) is added to the photosensitive silicone resin composition according to the present invention for the purpose of imparting photosensitivity. Photoradical polymerization and/or photocationic polymerization of the photosensitive silicone resin composition can be allowed to proceed by adding the photopolymerization initiator (B). The photopolymerization initiator (B) is preferably a compound listed below having absorption at a wavelength of 365 nm.

Photoradical Polymerization Initiators:

(1) benzophenone derivatives: examples include benzophenone, 4,4'-bis(diethylamino)benzophenone, methyl o-benzoylbenzoate, 4-benzoyl-4'-methyl diphenyl ketone, dibenzoyl ketone and fluorenone;

(2) acetophenone derivatives: examples include trichloroacetophenone, 2,2'-diethoxyacetophenone, 2-hydroxy-2-methylpropionphenone, 2,2-dimethoxy-1,2-diphenylethan-1-one, 1-hydroxycyclohexylphenyl ketone, 2-methyl-1-[4-(methylthio)phenyl]-2-morpholinopropan-1-one, 2-hydroxy-1-{4-[4-(2-hydroxy-2-methylpropionyl)-benzyl]-phenyl}-2-methylpropan-1-one, methyl phenylglyoxylate, and (2-hydroxy-1-{4-[4-(2-hydroxy-2-methyl-propionyl)-benzyl]- phenyl}-2-methyl-propan-1-one) (BASE SE, Irgacure® 127) ;

(3) thioxanthone derivatives: examples include thioxanthone, 2-methylthioxanthone, 2-isopropylthioxanthone and diethylthioxanthone;

(4) benzyl derivatives: examples include benzyl, benzyl dimethyl ketal and benzyl-β-methoxyethyl acetal;

(5) benzoin derivatives: examples include benzoin, benzoin methyl ether and 2-hydroxy-2-methyl-1-phenylpropan-1-one;

(6) oxime-based compounds: examples include 1-phenyl-1,2- butanedione-2-(O-methoxycarbonyl)oxime, 1-phenyl-1,2-propanedione-2-(O-methoxycarbonyl)oxime, 1-phenyl-1,2-propanedione-2-(O-ethoxycarbonyl)oxime, 1-phenyl-1,2-propanedione-2-(O-benzoyl)oxime, 1,3-diphenylpropanedione-2-(O-ethoxycarbonyl)oxime, 1-phenyl-3-ethoxypropanedione-2-(O-benzoyl)oxime, 1,2-octanedione, 1-[4-(phenylthio)-2-(O-benzoyloxime)] (BASF SE, Irgacure® OXE01), ethanone, and 1-[9-ethyl-6- (2-methylbenzoyl)-9H-carbozol-3-yl]-1-(O-acetyloxime) (BASF SE, Irgacure® OXE02);

(7) α-hydroxyketone-based compounds: examples include 2-hydroxy-2-methyl-1-phenylpropan-1-one, 1-[4-(2-hydroxyethoxy)phenyl]-2-hydroxy-2-methyl-1-propan- 1-one, and 2-hydroxy-1-{4-[4-(2-hydroxy-2-methylpropionyl) benzyl]phenyl}-2-methylpropane;

(8) α-aminoalkylphenone-based compounds: examples include 2-benzyl-2-dimethylamino-1-(4-morpholinophenyl)-butanone-1 (BASF SE, Irgacure® 369), and 2-dimethylamino-2-(4- methylbenzyl)-1-(4-morpholin-4-yl-phenyl) butan-1-one;

(9) phosphine oxide-based compounds: examples include bis(2,4,6-trimethylbenzoyl)-phenylphosphine oxide, bis(2,6-dimethoxybenzoyl)-2,4,4-trimethyl-pentylphosphine oxide, and 2,4,6-trimethylbenzoyl-diphenyl-phosphine oxide (BASF SE, Lucirin® TPO);

(10) titanocene compounds: examples include bis(η5-2,4-cyclopentadien-1-yl)-bis(2,6-difluoro-3-(1H- pyrrol-1-yl) phenyl) titanium;

(11) benzoate derivatives: examples include ethyl-p-(N,N-dimethylaminobenzoate); and,

(12) acridine derivatives: examples include 9-phenylacridine.

Photocationic Polymerization Initiators:

Examples include aryl diazonium salts having as an anion thereof $PF_6^-$, $AsF_6^-$, $SbF_6^-$, $SbCl_6^{2-}$, $BF_4^-$, $SnCl_6^-$, $FeCl_4^-$ or $BiCl_5^{2-}$. In addition, diaryl iodinium salts, triaryl sulfonium salts or triaryl selenium salts can be used having as an anion thereof $PF_6^-$, $AsF_6^-$, $SbF_6^-$, $SbCl_6^{2-}$, $BF_4^-$, $ClO_4^-$, $CF_3SO_3^-$, $FSO_3^-$, $F_2PO_2^-$ or $B(C_6F_5)_4^-$. Moreover, examples include dialkyl phenacyl sulfonium salts, dialkyl-4-hydroxyphenyl sulfonium salts, α-hydroxymethylbenzoin sulfonic acid esters, N-hydroxyimidosulfonates, sulfonic acid esters such as α-sulfonyloxy ketones or β-sulfonyloxy ketones, iron allene compounds, silanol-aluminum complexes and o-nitrobenzyl-triphenylsilyl ethers having as an anion thereof $PF_6^-$, $AsF_6^-$ or $SbF_6^-$ and the like. Additional examples include aryl diazonium salts having $PF_6^-$ and $AsF_6^-$.

Examples of commercially available products include SP-150, SP-152, SP-170 and SP-172 (optomers, Adeka Corp.). A photoradical polymerization initiator and a photocationic polymerization initiator may each be used alone or a plurality thereof may be used as a mixture, and although the photoradical polymerization initiator and the photocationic polymerization initiator may be used in combination, a photoradical polymerization initiator is preferable from the viewpoint of curability.

Among the aforementioned photoradical polymerization initiators, the acetophenone derivatives of (2) above, the α-aminoalkylphenone derivatives of (8) above and the phosphine oxide-based compounds of (9) above are preferable from the viewpoint of high sensitivity. Moreover, the phosphine oxide-based compounds of (9) above, and particularly the 2,4,6-trimethylbenzoyl-diphenyl-phosphine oxide (BASF SE, Lucirin® TPO), are preferable from the viewpoints of high transparency and high sensitivity of molded products.

Among the aforementioned photocationic polymerization initiators, iodinium salt type initiators are particularly preferable from the viewpoint of compatibility with the polysiloxane compound (a). For example, an iodinium salt type initiator is available as iodinium {4-{2-methylpropyl} phenyl}}{4-methylphenylhexafluorophosphate} (BASF SE, Irgacure® 250) represented by the following structural formula is available commercially.

In addition, a photopolymerization initiator, sensitizer or thermal radical initiator may also be used in combination, and various types of organic peroxides can be used for the thermal radical initiator, examples of which include ketone peroxide-based, peroxide ketal-based, hydroperoxide-based, dialkylperoxide-based, diacylperoxide-based, peroxydicarbonate-based and peroxyester-based organic peroxides.

Although dependent on the amounts of other additive components, the amount of the photopolymerization initiator (B) is preferably 0.01 parts by weight to 50 parts by weight, more preferably 0.05 parts by weight to 10 parts by weight, and even more preferably 0.1 parts by weight to 5 parts by weight based on 100 parts by weight of the silica particle-containing condensation reaction product (A). If the amount is 0.01 parts by weight or more, an amount of active species required for photopolymerization to proceed adequately is supplied during exposure, and since curing of the exposed portion proceeds adequately, a practical cured molded product can be obtained, while if the amount is 50 parts by weight or less, since exposure and absorption near the surface of a coated film do not become excessively large, exposure light reaches the vicinity of a substrate surface, and photopolymerization is uniform in the direction of film thickness, a practical cured molded product can be obtained, and there is little coloring after photocuring or after baking with heat.

[Compound (C) having a Photopolymerizable Functional Group in a Molecule thereof]

A compound (C) having a photopolymerizable functional group in a molecule thereof is preferably added to the photosensitive silicone resin composition according to the present invention for the purpose of providing a photosensitive resin composition having superior properties including improved refractive index, improved curability, improved adhesion, improved flexibility of cured molded products, and improved handling ease due to lowering the viscosity of the photosensitive resin composition. One type of the compound (C) having a photopolymerizable functional group in a molecule thereof may be used alone or two or more types may be used as a mixture. Examples of the photopolymerizable functional group of the compound (C) include a (meth)acryloyl group, epoxy group, glycidyl group, oxetane, vinyl ether, mercapto group, styryl group, norborneyl group, vinyl group, allyl group and other groups having an unsaturated carbon bond, and hydrogen groups of these various hydrocarbon groups or a portion of the main chain skeleton may be partially substituted with substituents selected from polar groups (polar bonds), such as a hydrocarbon group, ether bond, ester group (bond), hydroxyl group, thioether group, carbonyl group, carboxyl group, carboxylic anhydride bond, thioether bond, sulfone group, aldehyde group, epoxy group, amino group, substituted amino group, amido group (bond) imido group (bond), imino group, urea group (bond), urethane group (bond), isocyanate group or cyano group, or a halogen atom such as a fluorine atom, chlorine atom or bromine atom, and a (meth)acryloyl group and/or styryl group is more preferable from the viewpoint of curability, an epoxy group and/or a mercapto group is more preferable from the viewpoint of low cure shrinkage during curing, and a (meth)acryloyl group is even more preferable from the viewpoint of ease of adjusting viscosity and refractive index resulting from the use of numerous types of compounds.

Examples of compounds having a (meth)acryloyl group in a molecule thereof include 2-(meth)acryloyloxyethylphthalate, 2-(meth)acryloyloxyethyl-2-ethylhydroxyethylphthalate, 2-(meth)acryloyloxyethylhexahydrophthalate, 2-(meth)acryloyloxypropylphthalate, 2-ethyl-2-butylpropanediol (meth)acrylate, 2-ethylhexyl (meth)acrylate, 2-ethylhexylcarbitol (meth)acrylate, 2-hydroxybutyl (meth)acrylate, 2-hydroxyethyl (meth)acrylate, 2-hydroxypropyl (meth)acrylate, 2-methoxyethyl (meth)acrylate, 3-methoxybutyl (meth)acrylate, 4-hydroxybutyl (meth)acrylate, benzyl (meth)acrylate, butandiol mono(meth)acrylate, butoxyethyl (meth)acrylate, butyl (meth)acrylate, caprolactone (meth)acrylate, cetyl (meth)acrylate, EO-modified cresol (meth)acrylate, cyclohexyl (meth)acrylate, dicyclopentanyl (meth)acrylate, dicyclopentenyl (meth)acrylate, dicyclopentenyloxyethyl (meth)acrylate, diethylene glycol monoethyl ether (meth)acrylate, dimethyloldicyclopentane di(meth)acrylate, dipropylene glycol (meth)acrylate, ethoxydiethylene glycol (meth)acrylate, ethoxylated phenyl (meth)acrylate, ethyl (meth)acrylate, isoamyl (meth)acrylate, isobornyl (meth)acrylate, isobutyl (meth)acrylate, isodecyl (meth)acrylate, isooctyl (meth)acrylate, isostearyl (meth)acrylate, isomyristyl (meth)acrylate, lauroxypolyethylene glycol (meth)acrylate, lauryl (meth)acrylate, methoxydipropylene glycol (meth)acrylate, methoxytripropylene glycol (meth)acrylate, methoxypolyethylene glycol (meth)acrylate, methoxytriethylene glycol (meth)acrylate, methyl (meth)acrylate, neopentyl glycol benzoate (meth)acrylate,

octoxypolyethylene glycol-polypropylene glycol (meth)acrylate, octyl(meth)acrylate, decyl(meth)acrylate, para-cumylphenoxyethylene glycol (meth)acrylate, ECH-modified phenoxy (meth)acrylate, phenoxydiethylene glycol (meth)acrylate, phenoxyethyl (meth)acrylate, phenoxyhexaethylene glycol (meth)acrylate, phenoxytetraethylene glycol (meth)acrylate, poly(ethylene glycol-tetramethylene glycol) (meth)acrylate, poly(propylene glycol-tetramethylene glycol) (meth)acrylate, polyethylene glycol (meth)acrylate, polyethylene glycol-polypropylene glycol (meth)acrylate, polypropylene glycol (meth)acrylate, stearyl (meth)acrylate, t-butyl (meth)acrylate, t-butylcyclohexyl (meth)acrylate, tetrahydrofurfuryl (meth)acrylate, tridecyl (meth)acrylate, di(meth)acrylic isocyanurate, 1,3-butylene glycol di(meth)acrylate, 1,4-butanediol di(meth)acrylate, 1,6-hexanediol di(meth)acrylate, (meth)acryloyloxypolyethylene glycol (meth)acrylate, 1,9-nonanediol di(meth)acrylate, tetraethylene glycol di(meth)acrylate, tricyclodecane dimethanol di(meth)acrylate, para-phenylphenoxyethyl (meth)acrylate, para-phenylphenyl (meth)acrylate, phenyl glycidyl ether (meth)acrylate, phenol (meth)acrylate modified with 3 to 15 moles of ethylene oxide, cresol (meth)acrylate modified with 1 to 15 moles of ethylene oxide, nonylphenol (meth)acrylate modified with 1 to 20 moles of ethylene oxide, nonylphenol (meth)acrylate modified with 1 to 15 moles of propylene oxide, di(meth)acrylate containing 1 to 30 moles of an ethylene glycol chain, di(meth)acrylate containing 1 to 30 moles of a propylene glycol chain, bisphenol A di(meth)acrylate modified with 1 to 30 moles of ethylene oxide, bisphenol A di(meth)acrylate modified with 1 to 30 moles or propylene oxide, bisphenol F di(meth)acrylate modified with 1 to 30 moles of ethylene oxide, bisphenol F di(meth)acrylate modified with 1 to 30 moles of propylene oxide, ditrimethylolpropane tetra(meth)acrylate, tetramethylolmethane tri(meth)acrylate, tetramethylolmethane tetra(meth)acrylate, dipentaerythritol penta(meth)acrylate, dipentaerythritol hexa(meth)acrylate, pentaerythritol tetra(meth)acrylate, pentaerythritol tri(meth)acrylate, trimethylolpropane (meth)acrylate, trimethylolpropane tri(meth)acrylate modified with 1 to 15 moles of propylene oxide, trimethylolpropane tri(meth)acrylate modified with 1 to 20 moles of ethylene oxide, pentaerythritol tetra(meth)acrylate modified with 1 to 20 moles of ethylene oxide, glyceryl tri(meth)acrylate, modified with 1 to 20 moles of ethylene oxide, glyceryl tri(meth)acrylate modified with 1 to 20 moles of propylene oxide, glycerol tri(meth)acrylate, ethylated pentaerythritol tri(meth)acrylate, dipentaerythritolhydroxy penta(meth)acrylate, dipentaerythritol penta(meth)acrylate modified with 1 mole of alkyl groups, dipentaerythritol tetra(meth)acrylate modified with 2 moles of alkyl groups, dipentaerythritol tri(meth)acrylate modified with 3 moles of alkyl groups, pentaerythritolethoxy tetra(meth)acrylate, n-hexyl (meth)acrylate, n-decyl (meth)acrylate, dicyclopentenyloxyethyl (meth)acrylate, tripropylene glycol di(meth)acrylate, 1,6-hexanediol di(meth)acrylate, bisphenol A diglycidyl ether (meth)acrylate, hydroxypivalic acid neopentyl glycol di(meth)acrylate, pentacyclo [6.5.1.1$^{3.6}$.0$^{2.7}$.0$^{9.13}$] pentadecanedimethylol di(meth)acrylate, and dicyclopentanyldimethylol di(meth)acrylate.

The amount added of the compound having a (meth)acryloyl group in a molecule thereof is preferably 0 parts by weight to 900 parts by weight, and more preferably 5 parts by weight to 300 parts by weight based on 100 parts by weight of the silica particle-containing condensation reaction product (A). By adding the compound having a (meth)acryloyl group in a molecule thereof to the silica particle-containing condensation reaction product (A), the formation of cracks caused by thermal shock can be prevented. If the amount added of the compound having a (meth)acryloyl group in a molecule thereof is 900 parts or less based on 100 parts by weight of the silica particle- containing condensation reaction product (A), a cured molded product is able to have an even higher refractive index, higher transmittance and higher heat resistance.

The containing of a compound having a carbon ring and/or heterocyclic compound in the photosensitive resin composition for the aforementioned compound (C) is preferable from the viewpoints of maintaining refractive index, improving Abbe's number, lowering cure shrinkage and improving hardness of cured molded products.

Examples thereof include 2-(meth)acryloyloxyethyl phthalate, 2-(meth)acryloyloxyethyl-2-ethylhydroxyethyl phthalate, 2-(meth)acryloyloxyethylhexahydrophthalate, 2-(meth)acryloyloxypropyl phthalate, benzyl(meth)acrylate, EO-modified cresol (meth)acrylate, cyclohexyl (meth)acrylate, dicyclopentanyl (meth)acrylate, dicyclopentenyl (meth)acrylate, dicyclopentenyloxyethyl (meth)acrylate, dimethyloldicyclopentane di(meth)acrylate, ethoxylated phenyl (meth)acrylate, isobornyl (meth)acrylate, para-cumylphenoxyethylene glycol (meth)acrylate, ECH-modified phenoxy (meth)acrylate, phenoxydiethylene glycol (meth)acrylate, phenoxydiethyl (meth)acrylate, phenoxyhexaethylene glycol (meth)acrylate, phenoxytetraethylene glycol (meth)acrylate, tricyclodecanedimethanol di(meth)acrylate, para-phenylphenoxyethyl (meth)acrylate, para-phenylphenyl (meth)acrylate, phenylglycidyl ether (meth)acrylate, phenol (meth)acrylate modified with 3 to 15 moles of ethylene oxide, cresol (meth)acrylate modified with 1 to 15 moles of ethylene oxide, nonylphenol (meth)acrylate modified with 1 to 20 moles of ethylene oxide, nonylphenol (meth)acrylate modified with 1 to 15 moles of propylene oxide, bisphenol A di(meth)acrylate modified with 1 to 30 moles of ethylene oxide, bisphenol A di(meth)acrylate modified with 1 to 30 moles of propylene oxide, bisphenol F di(meth)acrylate modified with 1 to 30 moles of ethylene oxide, bisphenol F di(meth)acrylate modified with 1 to 30 moles of propylene oxide, bisphenol A diglycidyl ether di (meth) acrylate, pentacyclo [6.5.1.1$^{3.6}$.0$^{2.7}$.0$^{9.13}$] pentadecanedimethylol di(meth)acrylate, dicyclopentanyldimethylol di(meth) acrylate, tetrahydrofurfuryl (meth)acrylate, caprolactone-modified tetrahydrofurfuryl (meth)acrylate, di(meth)acrylic isocyanurate, neopentyl glycol-modified trimethylolpropane di(meth)acrylate, tris((meth)acryloxyethyl)isocyanurate, imido (meth)acrylate, pentamethylpiperidyl (meth)acrylate and tetramethylpiperidyl (meth)acrylate.

In particular, at least one compound selected from the group consisting of dicyclopentanyl (meth)acrylate, dicyclopentenyl (meth)acrylate, dicyclopentenyloxyethyl (meth)acrylate, dimethyloldicyclopentane di(meth)acrylate, tricyclodecanedimethanol di(meth)acrylate and isobornyl (meth)acrylate is preferable for the (meth)acrylate compound having a carbon ring and/or heterocyclic compound from the viewpoint of improving refractive index and Abbe's number as well as availability.

In addition, a reactive oligomer may also be added as the compound (C) having a photopolymerizable functional group in a molecule thereof, and examples of reactive oligomers include unsaturated polyesters, polyene/thiols, polybutadiene and polystyrylethyl methacrylate. Although monofunctional unsaturated compounds and polyfunctional unsaturated compounds are included in these reactive oligomers, both monofunctional unsaturated compounds and polyfunctional unsaturated compounds may be used, and a plurality of compounds may be also be used as a mixture. Although dependent on the amounts of other additives added, the amount of the aforementioned reactive oligomer added in the case of addition thereof is preferably 0 parts by weight to 900 parts by weight based on 100 parts by weight of the silica particle-containing condensation reaction product (A), and if added at 900 parts by weight or less, cured molded products are able to have an even higher refractive index, higher transmittance and higher heat resistance.

An adhesion promoter may also be added to the resin composition of the present invention as the compound (C) having a photopolymerizable functional group in a molecule thereof for the purpose of improving adhesion to various types of support bases. Examples of adhesion promoters include silane coupling agents, and specific examples include organic alkoxysilane compounds such as alkoxysilanes containing a hydrogen atom directly bonded to a nitrogen atom, alkoxysilanes containing an epoxy group or thiol group, or alkoxysilanes containing an unsaturated bond such as a vinyl group, as well as compounds in which all or a portion of the alkoxysilanes of these organic alkoxysilane compounds have been hydrolyzed and condensation products thereof. Examples include vinyltrichlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2(aminoethyl)-3-aminopropyltrimethoxysilane, N-2(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, N-(vinylbenzyl)-2-aminoethyl-3-aminopropyltrimethoxysilane hydrochloride, 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl) tetrasulfide, 3-isocyanatepropyltriethoxysilane, vinyltris(2-methoxyethoxy)silane, vinylmethyldimethoxysilane, 3-mercaptopropyltriethoxysilane, 3-octanoylthio-1-propyltriethoxysilane, 3-isocyanatepropyltrimethoxysilane, 3-triethoxysilyl-N-(1,3-dimethyl-butylidene), 3-acryloxypropyltrimethoxysilane, N-(p-vinylbenzyl)-N-(trimethoxysilylpropyl)ethylenediamine hydrochloride, 3-glycidoxypropylmethyldimethoxysilane, bis[3-(triethoxysilyl)propyl]disulfide, vinyltriacetoxysilane, vinyltriisopropoxysilane, allyltrimethoxysilane, diallyldimethylsilane, 3-mercaptopropyltriethoxysilane and N-(1,3-dimethylbutylidene)-3-aminopropyltriethoxysilane.

Although dependent on the amounts of other additive components, the added amount of the aforementioned silane coupling agent is preferably 0.01 parts by weight to 10 parts by weight and more preferably 0.05 parts by weight to 5 parts by weight based on 100 parts by weight of the silica particle- containing condensation reaction product (A). The amount of coupling agent added is preferably 0.01 parts by weight or more based on 100 parts by weight of the silica particle-containing condensation reaction product (A) from the viewpoint of improving adhesion, and is preferably 10 parts by weight or less from the viewpoint of storage stability.

The lower limit of the equivalent of photopolymerizable functional groups of the photosensitive silicone resin composition is preferably 0.5 mmol/g or more, more preferably 1.0 mmol/g or more and even more preferably 1.2 mmol/g or more from the viewpoint of crack resistance. In addition, the upper limit of the equivalent of photopolymerizable functional groups of the photosensitive silicone resin composition is preferably 4.5 mmol/g or less, more preferably 4.0 mmol/g or less and even more preferably 3.5 mmol/g or less from the viewpoint of volumetric shrinkage when curing by irradiating with light.

Here, the equivalent of photopolymerizable functional groups refers to the number of moles of the equivalent of photopolymerizable functional groups per gram of the photosensitive silicone resin composition, and the photopolymerizable functional groups are derived from the silica particle-containing condensation reaction product (A) and the compound (C) having a photopolymerizable functional group in a molecule thereof. The equivalent of photopolymerizable functional groups derived from the silica particle-containing condensation reaction product (A) can be calculated by dividing the molar amount of photopolymerizable functional groups in the raw materials used when producing the silica particle-containing condensation reaction product (A) by the weight of the resulting silica particle-containing condensation reaction product (A), and the equivalent of photopolymerizable functional groups derived from the compound (C) having a photopolymerizable functional group in a molecule thereof can be calculated by dividing the number of photopolymerizable functional groups in a molecule thereof by molecular weight. When the equivalent of photopolymerizable functional groups of the silica particle-containing condensation reaction product (A) is defined as X(A), the equivalent of photopolymerizable functional groups of the compound (C) having a photopolymerizable functional group in a molecule thereof is defined as X(C), the weight ratio of the silica particle-containing condensation reaction product (A) in the photosensitive silicone resin composition is defined as Y(A), and the weight ratio of the compound (C) having a photopolymerizable functional group in a molecule thereof is defined as Y(C), then the equivalent of photopolymerizable functional groups of the photosensitive silicone resin composition can be calculated by X(A) x Y(A) + X(C) x Y(C).

[Antioxidant and/or Ultraviolet Absorber (D)]

An antioxidant and/or ultraviolet absorber (D) may also be added to the photosensitive silicone resin composition according to the present invention from the viewpoint of improving heat resistance and light resistance. Examples of the antioxidant and/or ultraviolet absorber (D) include the substances listed below:

(1) hindered phenol-based antioxidants:

pentaerythritoltetrakis[3-(3,5-di-tert-butyl-4-hydroxyphenyl)propionate], thiodiethylenebis[3-(3,5-di-tert-butyl-4-hydroxyphenyl)propionate], octadecyl-3-(3,5-di-tert-butyl-4-hydroxyphenyl)propionate, N,N'-hexan-1,6-diylbis [3-(3,5-di-tert-butyl-4-hydroxyphenyl)propionamide], benzenepropanoic acid,3,5-bis(1,1-dimethylethyl)-4-hydroxy C7-C9 side chain alkyl ester, 3,3',3'',5,5',5''-hexa-tert- butyl-a,a',a''-(mesitylen-2,4,6-triyl)tri-p-cresol, calcium diethylbis[[3,5-bis(1,1-dimethylethyl)-4-hydroxyphenyl] methyl]phosphonate], 4,6-bis(octylthiomethyl)-o-cresol, 4,6-bis(dodecylthiomethyl)-o-cresol, ethylenebis(oxyethylene)bis[3-(5-tert-butyl-4-hydroxy-m-tolyl)propionate], hexamethylenebis[3-(3,5-di-tert-butyl-4- hydroxyphenyl)propionate], 1,3,5-tris(3,5-di-tert-butyl-4- hydroxybenzyl)-1,3,5-triazine-2,4,6-(1H,3H,5H)-trione, reaction products of N-phenylbenzeneamine and 2,4,4-trimethylpentene, 2,4,6-tert-butyl-4-(4,6-bis (octylthio)-1,3,5-triazin-2-ylamino)phenol and 2,4-dimethyl- 6-(1-methylpentadecyl)phenol;

(2) phosphorous-based heat stabilizers: tris(2,4-di-tert-butylphenyl)phosphate and bis[2,4-bis(1,1-dimethylethyl)-6-methylphenyl]ethyl ester phosphorous acid;
(3) iodine-based heat stabilizers: dodecyl-3,3'-thiodipropionate and dioctadecyl-3,3'-thiodipropionate;

(4) benzotriazole-based ultraviolet absorbers: 2-(2H-benztriazol-2-yl)-p-cresol, 2-(2H-benzatriazol-2-yl)-4,6-bis(1-methyl-1-phenylethyl) phenol, 2-[5-chloro(2H)-benzotriazol-2-yl]-4-methyl-6- (tert-butyl)phenol, 2-(2H-benzotriazol-2-yl)-4,6-di-tert- pentylphenol, 2-(2H-benzotriazol-2-yl)-4-(1,1,3,3- tetramethylbutyl)phenol, 2,2'-methylenebis [6-(2H- benzotriazol-2-yl)-4-(1,1,3,3-tetramethylbutyl)phenol], reaction products of methyl 3-(3-(2H-benzotriazol-2-yl)-5- tert-butyl-4-hydroxyphenyl)proprionate and ethylene glycol 300, and 2-(2H-benzotriazol-2-yl)-6-dodecyl-4-methylphenol;
(5) cyanoacrylate-based ultraviolet absorbers: 2,2-bis{[2-cyano-3,3-diphenylacryloyl]methyl}propan-1,3-diyl=bis(2-cyano-3,3-diphenylacrylate), 2-cyano-3,3-diphenylacrylic acid ethyl ester and 2-cyano-3,3-diphenylacrylic acid 2-ethylhexyl ester;
(6) triazine-based ultraviolet absorbers: 2-(4,6-diphenyl-1,3,5-triazin-2-yl)-5-[(hexyl)oxy]-phenol;

(7) benzophenone-based ultraviolet absorbers:

octabenzone, 2,2'-dihydroxy-4,4'-dimethoxybenzophenone and 2,2'-4,4'- tetrahydrobenzophenone;

(8) hindered amine-based photothermal stabilizers:

dibutylamine, polycondensation products of 1,3,5-triazine'N,N'-bis(2,2,6,6-tetramethyl-4-piperidyl)-1,6-hexamethylenediamine and N-(2,2,6,6-tetramethyl-4-piperidyl) butylamine, poly[{6-(1,1,3,3-tetramethylbutyl)amino-1,3,5- triazin-2,4-diyl}{(2,2,6,6-tetramethyl-4-piperdiyl)imino} hexamethylene{(2,2,6,6-tetramethyl-4-piperidyl)imino}], polymers of dimethyl succinate and 4-hydroxy-2,2,6,6- tetramethyl-1-piperidine ethanol, olefin (C20-C24) maleic anhydride 4-amino-2,2,6,6-tetramethylpiperidine copolymers, bis(1,2,2,6,6-pentamethyl-4-piperidine)[[3,5-bis(1,1- dimethylethyl)-4-hydroxyphenyl]methyl]butyl malonate, bis(1,2,2,6,6-pentamethyl-4-piperidyl) sebacate, methyl- 1,2,2,6,6-pentamethyl-4-piperidyl sebacate, bis(2,2,6,6-tetramethyl-4-piperidyl) sebacate, N,N'-bis(2,2,6,6-tetramethyl-4-piperidyl)-N,N'-diformylhexamethylenediamine;

(9) other heat stabilizers: 3,4-dihydro-2,5,7,8-tetramethyl-2-(4,8,12-trimethyltridecyl)-2H-benzopyrano-6- ol, 2',3-bis[[3-[3,5-di-tert-butyl-4-hydroxyphenyl] propionyl]]propionohydrazide; and
(10) other ultraviolet absorbers: 2-ethylhexyl-4-methoxycinnamide and 2,4-di-tert-butylphenyl-3,5-di-tert-butyl-4-hydroxybenzoate.

The antioxidant and/or ultraviolet absorber (D) is more preferably a hindered phenol-based antioxidant of (1) above and a hindered amine-based photothermal stabilizer of (7) above from the viewpoint solubility in the photosensitive silicone resin composition, and even more preferably ethylenebis (oxyethylene)bis[3-(5-tert-butyl-4-hydroxy-m-tolyl) propionate] (BASF SE, Irganox® 245).
The antioxidant and/or ultraviolet absorber (D) may be used alone or a plurality may be used in combination.
Although dependent on the amounts of other additive components, the amount of the antioxidant and/or ultraviolet absorber (D) is preferably 0 parts by weight to 50 parts by weight, more preferably greater than 0 parts by weight to 5 parts by weight, and even more preferably 0.1 parts by weight to 2 parts by weight based on 100 parts by weight of the silica particle- containing condensation reaction product (A).
Addition of the antioxidant and/or ultraviolet absorber (D) improves heat stability in a nitrogen atmosphere as well as heat stability in an air atmosphere.
In addition to the aforementioned components (A) to (D), an inorganic filler may be further added to the photosensitive silicone resin composition of the present invention. The organic filler preferably has a mean particle diameter that is equal to or less than the wavelength used in the target application in order to avoid detrimental effects on light transmittance, and the mean particle diameter thereof is preferably 100 nm or less. Inorganic fillers may improve mechanical properties or improve thermal conductivity in a resin. Although there are no particular limitations thereon, the lower limit of mean particle diameter of the inorganic filler is preferably 0.1 nm or more since the viscosity of the resin composition is low and it has favorable moldability. Furthermore, the aforementioned mean particle diameter is a value determined by calculating from the BET specific surface area. Although the amount of inorganic filler can be selected according to the objective and is dependent on the amount of other additive components, it is preferably, for example, 1 part by weight to 60 parts by weight, more preferably 5 parts by weight to 60 parts by weight and even more preferably 5 parts by weight to 40 parts by weight based on 100 parts by weight of the silica particle-containing condensation reaction product (A).
In addition to the aforementioned components (A) to (D), a solvent may be further added to the photosensitive silicone resin composition of the present invention to adjust viscosity. Preferable examples of solvents include N,N-dimethylformamide, N-methyl-2-pyrrolidone, N-ethyl-2-pyrrolidone, tetrahydrofuran, N,N-dimethylacetoamide, dimethylsulfoxide, hexamethylphosphoramide, pyridine, cyclopentanone, γ-butyrolactone, α-acetyl-γ-butyrolactone, tetramethyl urea, 1,3-dimethyl-2-imidazolinone, N-cyclohexyl-2-pyrrolidone, propylene glycol monomethyl ether, PGMEA, methyl ethyl ketone, methyl isobutyl ketone, anisole, ethyl acetate, ethyl lactate and butyl lactate, and one type of these can be used alone or two or more types can be used in combination. Among these solvents, N-methyl-2-pyrrolidone, γ-butyrolactone and PGMEA are particularly preferable. Although these solvents can be suitably added to the photosensitive silicone resin composition according to coated film thickness and viscosity, they are preferably used within the range of 0 parts by weight to 900 parts by weight based on 100 parts by weight of the silica particle-containing condensation reaction product (A).
In addition to the aforementioned components (A) to (D), a sensitizer for improving photosensitivity can be further added to the photosensitive silicone resin composition according to the present invention. Examples of sensitizers include Michler's ketone, 4,4'-bis(diethylamino)benzophenone, 2,5-bis(4'-diethylaminobenzylidene)cyclopentanone, 2,6-bis(4'-diethylaminobenzylidene)cyclohexanone, 2,6- bis(4'-dimethylaminobenzylidene)-4-methylcyclohexanone, 2,6-bis(4'-diethylaminobenzylidene)-4-methylcyclohexanone, 4,4'-bis(diethylamino)chalcone, 2-(4'-dimethylaminocinnamylidene)indanone, 2-(4'-dimethylaminobenzylidene)indanone, 2-(p-4'-dimethylaminobiphenyl)benzothiazole, 1,3-bis(4-dimethylaminobiphenyl)benzothiazole, 1,3-bis(4-diethylaminobenzylidene)acetone, 1,3-bis(4-diethylaminobenzylidene) acetone, 3,3'-carbonyl-bis(7-diethylaminocoumarin)acetone, 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin, N-phenyl-N-ethylethanolamine, N-phenyl-diethanolamine, N-p-tolyldiethanolamine, N-phenylethanolamine, N,N-bis(2-hydroxyethyl)aniline, 4-morpholinobenzophenone, 4-dimethylaminobenzoic acid isoamyl ester, 4-diethylaminobenzoic acid isoamyl ester, benzotriazole, 2-mercaptobenzimidazole, 1-phenyl-5-mercapto- 1,2,3,4-tetrazole, 1-cyclohexyl-5-mercapto-1,2,3,4- tetrazole, 1-(tert-butyl)-5-mercapto-1,2,3,4-tetrazole, 2-mercaptobenzothiazole, 2-(p-dimethylaminostyryl) benzoxazole, 2-(p-dimethylaminostyrylbenzthiazole, 2-(p-dimethylaminostyryl)naphtho(1,2-p)thiazole and 2-(p-dimethylaminobenzoyl)styrene.

In addition, these compounds may be used alone or two or more types may be used as a mixture. Although dependent on the amounts of other additive components, the amount of sensitizer added is preferably 0 parts by weight to 10 parts by weight and more preferably 1 part by weight to 5 parts by weight based on 100 parts by weight of the silica particle-containing condensation reaction product (A).

In addition to the aforementioned components (A) to (D), a polymerization inhibitor can be further added to the photosensitive silicone resin composition according to the present invention for the purpose of improving the stability of viscosity and photosensitivity during storage. Examples of polymerization inhibitors that can be used include hydroquinone, N-nitrosodiphenylamine, p-tert-butylcatechol, phenothiazine, N-phenylnaphthylamine, ethylenediamine tetraacetic acid, 1,2-cyclohexanediamine tetraacetic acid, glycol ether diamine tetraacetic acid, 2,6-di-tert-butyl-p-methylphenol, 5-nitoso-8-hydroxyquinoline, 1-nitoso-2-naphthol, 2-nitroso-1-naphthol, 2-nitroso-5-(N-ethyl-N-sulfopropylamino)phenol, N-nitroso-N-phenylhydroxyamine ammonium salt, N-nitroso-N-phenylhydroxylamine ammonium salt, N-nitroso-N-(1-naphthyl)hydroxylamine ammonium salt and bis(4-hydroxy-3,5-di-tert-butyl)phenylmethane. Although dependent on the amounts of other additive components, the amount of polymerization inhibitor added is preferably 0 parts by weight to 5 parts by weight and more preferably 0.01 parts by weight to 1 part by weight based on 100 parts by weight of the silica particle-containing condensation reaction product (A).

In addition to the aforementioned components (A) to (D), a lubricant, antistatic agent, mold release agent, foaming agent, nucleating agent, colorant, crosslinking agent, dispersion promoter, plasticizer or flame retardant and the like can also be further added to the resin composition of the present invention. These materials can be mixed with the resin composition and other arbitrary components using a known method such as centrifugation, and the resulting mixture is preferably degassed using a known method such as vacuum degassing.

In order to obtain the photosensitive silicone resin composition of the present invention, each component consisting of the aforementioned silica particle-containing condensation reaction product (A), the photopolymerization initiator (B), the compound (C) having a photopolymerizable functional group in a molecule thereof, and/or the antioxidant and/or ultraviolet absorber (D) can be placed in a glass container or plastic container and the like, and uniformly mixed using a commonly known stirring device such as a webbed rotor, magnetic stirrer or motor-driven stirrer or impeller.

The temperature during mixing is preferably 20°C to 80°C. The components can be uniformly mixed at 20°C or higher, and deterioration of each mixed component can be prevented at 80°C or lower.

<Curing Method of Photosensitive Silicone Resin Composition>

The method used to cure the resin composition of the present invention preferably consists of irradiating with light having a wavelength region of 200 nm to 500 nm and more preferably irradiating with having a wavelength region of 300 nm to 450 nm.

Examples of methods used to obtain a compact of the resin composition of the present invention include a method consisting of injecting into a mold having an arbitrary cavity shape and composed of a transparent material such as polydimethylsiloxane, fluorine-based transparent resin, cycloolefin-based transparent resin or glass, carrying out a polymerization reaction by irradiating with light having a wavelength region of 200 nm to 500 nm, and removing the mold to obtain a compact, and a method consisting of coating using a known method onto glass or Si substrate and carrying out a polymerization reaction by irradiating with light having a wavelength region of 200 nm to 500 nm to obtain a compact in the form of a sheet on the substrate.

Examples of light having a wavelength region of 200 nm to 500 nm include light from a xenon flash lamp, xenon short arc lamp, super-high-pressure UV lamp, high-pressure UV lamp, deep UV lamp, low-pressure UV lamp, KrCl or XeCl excimer lamp or metal halide lamp. There are no particular restrictions on the duration of irradiation with the aforementioned light having a wavelength region of 200 nm to 500 nm, and the resin composition of the present invention can be cured by irradiating for a period of time within the range of about 1 second to 20 minutes.

The oxygen concentration of the atmosphere during the aforementioned curing reaction is preferably 1% or less and more preferably 5000 ppm or less. More specifically, the curing reaction can be carried out under reduced pressure or while pressurizing in an atmosphere of an inert gas such as nitrogen, helium, neon, argon, krypton, xenon or carbon dioxide gas. One type of these gases can be used or two or more types can be used as a mixed gas.

After irradiating with light having a wavelength region of 200 nm to 500 nm, baking may be carried out at 130°C to 300°C. As a result of baking (heating) within the aforementioned range, optical properties such as refractive index or transmittance can be stabilized, thereby making this preferable. Although there are no particular restrictions on the baking time, normally baking is carried out for a period of time preferably within the range of about 1 minute to 10 hours.

A cured product obtained by photocuring the resin composition of the present invention can be preferably used as a plastic lens material (surface coating material) having various shapes used in, for example, the plastic lens of cell phones, LEDs or vehicles and the like, replica materials, backlighting optical sheets of liquid crystal displays and the like, lighting, various types of sensors, printers and copying machines.

A plastic lens that uses the resin composition of the present invention can be obtained by filling the resin composition of the present invention into a metal mold or plastic mold having the shape of a lens, or coating the resin composition of the present invention onto a roll or plate, transferring by pressing into the aforementioned mold, curing by irradiating with light using a light source having a wavelength region of 200 nm to 500 nm as described above, and releasing from the mold. From the viewpoint of improving the curing reaction rate, the resin composition filled into the mold is preferably covered with a plastic film, glass wafer or metal plate and the like, or is cured in an atmosphere having an oxygen concentration of 1% or less during the curing reaction of the resin composition using an inert gas under reduced pressure or while pressurizing as previously described. When curing the resin composition by irradiating with light, it is necessary that the light be transmitted between the light source and the resin composition, and in order to accomplish this, it is necessary to radiate the light from a transparent medium (such as a transparent resin mold, plastic film, glass wafer or in the absence of a base) through which light of the light source required for curing is transmitted. Coating the mold with a mold release agent or incorporating a mold release agent or mold releasing component in the mold and/or resin composition is preferable for improving releasability from the mold. A plastic lens fabricated by using the resin composition of the present invention can be optically used as a lens for a cell phone, LED or vehicle.

A replica material that uses the resin composition of the present invention can be obtained using the aforementioned method by filling the resin composition of the present invention into a metal mold or resin mold having a particular shape. The resulting replica material has the characteristic of high hardness, and durability can be improved by further subjecting to Ni electrocasting as necessary. Examples of shapes of the replica material include that of a lens, combination of lines and spaces, cylinder, prism, pyramid or honeycombs, and the shape can be selected according to the application or purpose.

A surface coating material that uses the resin composition of the present invention can be used in hard coating applications in the form of a cured product by taking advantage of the characteristic of high hardness by coating the resin composition of the present invention on the surface or within a (laminated) base followed by curing, and can be used in the form of a material in the shape of a film, sheet or plate having a shape as previously described.

Examples

Although the following provides a detailed explanation of the present invention through examples and comparative examples thereof, the present invention is not limited thereto.

<Synthesis of Silica Particle-Containing Condensation

Reaction Product and Preparation of Photosensitive Silicone Resin Composition>

[Example 1]

25.76 g (0.111 mol) of 3-methacryloxypropyl(methyl) dimethoxysilane (abbreviated as MEDMO), 15.10 g (0.111 mol) of methyltrimethoxysilane (abbreviated as MTMS) and 10 g of ethanol were placed in a 500 mL, eggplant-shaped flask and stirred. 19.96 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 1 containing the polysiloxane compound (a).

50 g of PL-1SL (Fuso Chemical Co., Ltd., water-dispersed silica particles having a mean primary particle diameter of 12 nm and concentration of 20% by weight) (silica particles (b)) and 50 g of ethanol were placed in a 500 mL eggplant-shaped flask and stirred. Continuing, the Reaction Liquid 1 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 2.14 g (0.027 mol) of pyridine were then added to this polymer and mixed followed by dropping in 2.67 g (0.025 mol) of trimethylchlorosilane (abbreviated as TMCS) (silicon compound (c)) over the course of 5 minutes while stirring. After stirring for 3 hours at room temperature, 10 g of water were added to the reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 1.

5% by weight of tricyclodecane dimethanol diacrylate, photopolymerization initiator in the form of 0.5% by weight of 2,4,6-trimethylbenzoyl-diphenyl-phosphine oxide (BASF SE, Lucirin® TPO) and 0.2% by weight of ethylenebis(oxyethylene) bis[3-(5-tert-butyl-4-hydroxy-m-tolyl)propionate] (BASF SE, Irganox® 245) were added to 94.3% by weight of the resulting Polymer 1 followed by stirring with a webbed rotor at room temperature until the added components dissolved to prepare a photosensitive silicon resin composition (P-1).

[Example 2]

15.46 g (0.067 mol) of MEDMO, 9.06 g (0.067 mol) of MTMS and 10 g of ethanol were placed in a 500 mL, eggplant-shaped flask and stirred. 11.97 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 2 containing the polysiloxane compound (a).

110 g of PL-1SL (silica particles (b)) and 100 g of ethanol were placed in a 500 mL eggplant-shaped flask and stirred. Continuing, the Reaction Liquid 2 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 1.29 g (0.016 mol) of pyridine were then added to this polymer and mixed followed by dropping in 1.60 g (0.015 mol) of TMCS (silicon compound (c)) over the course of 5 minutes while stirring. After stirring for 3 hours at room temperature, 10 g of water were added to the reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 2.

22% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl- 4-hydroxy-m-tolyl)propionate] were added to 77.3% by weight of the resulting Polymer 2 followed by stirring with a webbed rotor at room temperature until the added components dissolved to prepare a photosensitive silicon resin composition (P-2).

[Example 3]

5.88 g (0.025 mol) of MEDMO, 7.54 g (0.030 mol) of 3-methacryloxypropyltrimethoxysilane (abbreviated as MEMO), 6.67 g (0.035 mol) of cyclohexylmethyldimethoxysiloxane (abbreviated as CyMDMS) and 10 g of ethanol were placed in a 500 mL, eggplant-shaped flask and stirred. 7.65 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 3 containing the polysiloxane compound (a).

120 g of PL-1SL (silica particles (b)) and 100 g of ethanol were placed in a 500 mL eggplant-shaped flask and stirred. Continuing, the Reaction Liquid 3 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 0.88 g (0.011 mol) of pyridine were then added to this polymer and mixed followed by dropping in 1.10 g (0.010 mol) of TMCS (silicon compound (c)) over the course of 5 minutes while stirring. After stirring for 3 hours at room temperature, 10 g of water were added to the reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 3.

40% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl- 4-hydroxy-m-tolyl)propionate] were added to 59.3% by weight of the resulting Polymer 3 followed by stirring with a webbed rotor at room temperature until the added components dissolved to prepare a photosensitive silicon resin composition (P-3).

[Example 4]

A photosensitive silicone resin composition (P-4) was prepared by adding 0.5% by weight of photopolymerization initiator in the form of 2,4,6-dimethylbenzoyl-diphenyl- phosphine oxide to 99.5% by weight of the Polymer 1 obtained in Example 1 and stirring with a webbed rotor at room temperature until the photopolymerization initiator dissolved.

[Example 5]

A photosensitive silicone resin composition (P-5) was prepared by adding 10% by weight of tricyclodecane dimethanol diacrylate and 0.5% by weight of photopolymerization initiator in the form of 2,4,6-dimethylbenzoyl-diphenyl-phosphine oxide to 89.3% by weight of the Polymer 1 obtained in Example 1 and stirring with a webbed rotor at room temperature until the added components dissolved.

[Example 6]

14.40 g (0.062 mol) of MEDMO, 14.52 g (0.062 mol) of 3-acryloxypropyltrimethoxysilane (abbreviated as AcMO), 4.20 g (0.031 mol) of MTMS and 10 g of ethanol were placed in a 500 mL, eggplant-shaped flask and stirred. 14.50 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 4 containing the polysiloxane compound (a).
60 g of PL-1SL (silica particles (b)) and 70 g of ethanol were placed in a 500 mL eggplant-shaped flask and stirred. Continuing, the Reaction Liquid 4 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.
After refluxing, 60 g of PGMEA were further added and a distillation column was attached followed by removal of the ethanol and water to obtain a PGMEA solution.
15 g of PGMEA, 25 g of toluene and 4.49 g (0.057 mol) of pyridine were then added to this polymer and mixed followed by dropping in 5.60 g (0.052 mol) of TMCS (silicon compound (c)) over the course of 5 minutes while stirring. After stirring for 3 hours at room temperature, 10 g of water were added to the reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 4.
10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 4 followed by stirring with a webbed rotor at room temperature until the added components dissolved to prepare a photosensitive silicon resin composition (P-6).

[Example 7]

14.74 g (0.063 mol) of MEDMO, 14.21 g (0.063 mol) of p-styryltrimethoxysilane (abbreviated as StMO), 4.32 g (0.032 mol) of MTMS and 10 g of ethanol were placed in a 500 mL, eggplant-shaped flask and stirred. 14.84 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 5 containing the polysiloxane compound (a).
60 g of PL-1SL (silica particles (b)) and 70 g of ethanol were placed in a 500 mL eggplant-shaped flask and stirred. Continuing, the Reaction Liquid 5 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 4.60 g (0.058 mol) of pyridine were then added to this polymer and mixed followed by dropping in 5.73 g (0.053 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 5.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl- 4-hydroxy-m-tolyl)propionate] were added to 89.3% by weight of the resulting Polymer 5 followed by stirring with a webbed rotor at room temperature until the added components dissolved to prepare a photosensitive silicon resin composition (P-7).

[Example 8]

19.50 g (0.084 mol) of MEDMO, 6.61 g (0.028 mol) of 3-glycidoxypropyltrimethylsilane (abbreviated as GlyMO), 5.27 g (0.028 mol) of CyMDMS and 10 g of ethanol were placed in a 500 mL, eggplant-shaped flask and stirred. 11.08 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 6 containing the polysiloxane compound (a).

60 g of PL-1SL (silica particles (b)) and 70 g of ethanol were placed in a 500 mL eggplant-shaped flask and stirred. Continuing, the Reaction Liquid 6 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 4.06 g (0.051 mol) of pyridine were then added to this polymer and mixed followed by dropping in 5.06 g (0.047 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 6.

10% by weight of tricyclodecane dimethanol diacrylate, photopolymerization initiator in the form of 0.5% by weight of 2,4,6-trimethylbenzoyl-diphenyl-phosphine oxide and 0.5% by weight of iodinium {4-{2-methylpropyl}phenyl}}{4- methylphenylhexafluorophosphate} (BASF SE, Irgacure® 250),

and 0.2% by weight of ethylenebis(oxyethylene)bis[3-(5-tert-butyl-4-hydroxy-m-tolyl)propionate] were added to 88.8% by weight of the resulting Polymer 6 followed by stirring with a webbed rotor at room temperature until the added components dissolved to prepare a photosensitive silicon resin composition (P-8).

[Example 9]

19.31 g (0.083 mol) of MEDMO, 6.82 g (0.028 mol) of 2-(3,4-epoxycyclohexyl)ethyltrimethoxysilane (abbreviated as EpCyMO), 5.22 g (0.028 mol) of CyMDMS and 10 g of ethanol were placed in a 500 mL, eggplant-shaped flask and stirred. 10.97 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 7 containing the polysiloxane compound (a).

60 g of PL-1SL (silica particles (b)) and 70 g of ethanol were placed in a 500 mL eggplant-shaped flask and stirred. Continuing, the Reaction Liquid 7 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 4.02 g (0.051 mol) of pyridine were then added to this polymer and mixed followed by dropping in 5.01 g (0.046 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 7.

10% by weight of tricyclodecane dimethanol diacrylate, photopolymerization initiator in the form of 0.5% by weight of 2,4,6-trimethylbenzoyl-diphenyl-phosphine oxide and 0.5% by weight of iodinium {4-{2-methylpropyl}phenyl}}{4-methylphenylhexafluorophosphate} (BASF SE, Irgacure® 250),

and 0.2% by weight of ethylenebis(oxyethylene)bis[3-(5-tert-butyl-4-hydroxy-m-tolyl)propionate] were added to 88.8% by weight of the resulting Polymer 7 followed by stirring with a webbed rotor at room temperature until the added components dissolved to prepare a photosensitive silicon resin composition (P-9).

[Example 10]

19.38 g (0.083 mol) of MEDMO, 10.91 g (0.056 mol) of 3-mercaptopropyltrimethoxysilane (abbreviated as MeMO), 5.24 g (0.028 mol) of CyMDMS and 10 g of ethanol were placed in a 500 mL, eggplant-shaped flask and stirred. 14.01 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 8 containing the polysiloxane compound (a).

60 g of PL-1SL (silica particles (b)) and 70 g of ethanol were placed in a 500 mL eggplant-shaped flask and stirred. Continuing, the Reaction Liquid 8 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 1.61 g (0.020 mol) of pyridine were then added to this polymer and mixed followed by dropping in 2.01 g (0.019 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 8.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 8 followed by stirring with a webbed rotor at room temperature until the added components dissolved to prepare a photosensitive silicon resin composition (P-10).

[Example 11]

19.67 g (0.084 mol) of AcMO, 17.14 g (0.126 mol) of MTMS, 60 g of PL-1SL (silica particles (b)) and 70 g of ethanol were placed in a 500 mL, eggplant-shaped flask and stirred. 22.66 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 6.08 g (0.077 mol) of pyridine were then added to this polymer and mixed followed by dropping in 7.59 g (0.070 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 9.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 9 followed by stirring with a webbed rotor at room temperature until the added components dissolved to prepare a photosensitive silicon resin composition (P-11).

[Example 12]

19.40 g (0.087 mol) of StMO, 17.69 g (0.130 mol) of MTMS, 60 g of PL-1SL (silica particles (b)) and 70 g of ethanol were placed in a 500 mL, eggplant-shaped flask and stirred. 23.38 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 4 hours at 80°C in the presence of flowing nitrogen. After refluxing, 60 g of PGMEA were further added and a distillation column was attached followed by removal of the ethanol and water to obtain a PGMEA solution.

15 g of PGMEA, 25 g of toluene and 6.28 g (0.079 mol) of pyridine were then added to this polymer and mixed followed by dropping in 7.83 g (0.072 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 10.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 10 followed by stirring with a webbed rotor at room temperature until the added components dissolved to prepare a photosensitive silicon resin composition (P-12).

[Example 13]

18.59 g (0.095 mol) of MeMO, 19.35 g (0.142 mol) of MTMS and 10 g of ethanol were placed in a 500 mL, eggplant-shaped flask and stirred. 25.58 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 11 containing the polysiloxane compound (a).

60 g of PL-1SL (silica particles (b)) and 70 g of ethanol were placed in a 500 mL eggplant-shaped flask and stirred. Continuing, the Reaction Liquid 11 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 6.87 g (0.087 mol) of pyridine were then added to this polymer and mixed followed by dropping in 8.56 g (0.079 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 11.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 11 followed by stirring with a webbed rotor at room temperature until the added components dissolved to prepare a photosensitive silicon resin composition (P-13).

[Example 14]

13.28 g (0.057 mol) of MEDMO, 13.39 g (0.157 mol) of AcMO, 5.38 g (0.029 mol) of CyMDMS and 10 g of ethanol were placed in a 500 mL, eggplant-shaped flask and stirred. 12.34 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 12 containing the polysiloxane compound (a).

60 g of PL-1SL (silica particles (b)) and 70 g of ethanol were placed in a 500 mL eggplant-shaped flask and stirred. Continuing, the Reaction Liquid 12 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA and 25 g of toluene were then added to this polymer and mixed followed by dropping in 3.82 g (0.024 mol) of hexamethyldisilazene (abbreviated as HDMS) (silicon compound (c)) over the course of 5 minutes while stirring. Following dropping, a cooling tube was attached and the contents were refluxed for 1.5 hours at 60°C while bubbling nitrogen. The solvent was removed from the resulting reaction liquid under reduced pressure using a vacuum pump to obtain a silica particle-containing condensation reaction product in the form of Polymer 12.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 12 followed by stirring with a webbed rotor at room temperature until the added components dissolved to prepare a photosensitive silicon resin composition (P-14).

[Example 15]

23.91 g (0.103 mol) of MEDMO, 12.46 g (0.091 mol) of MTMS and 10 g of ethanol were placed in a 500 mL, eggplant-shaped flask and stirred. 17.29 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 13 containing the polysiloxane compound (a).

190.5 g of PL-06 (Fuso Chemical Co., Ltd., water-dispersed silica particles having a mean primary particle diameter of 6 nm and concentration of 6.3% by weight) (silica particles (b)) and 200 g of ethanol were placed in a 500 mL eggplant-shaped flask and stirred. Continuing, the Reaction Liquid 13 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 2.98 g (0.038 mol) of pyridine were then added to this polymer and mixed followed by dropping in 3.72 g (0.034 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 13.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 13 followed by stirring with a webbed rotor at room temperature until the added components dissolved to prepare a photosensitive silicon resin composition (P-15).

[Example 16]

25.76 g (0.111 mol) of MEDMO, 15.10 g (0.111 mol) of MTMS and 10 g of ethanol were placed in a 500 mL, eggplant-shaped flask and stirred. 19.96 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 14 containing the polysiloxane compound (a).

50 g of BS-1 (Fuso Chemical Co., Ltd., water-dispersed silica particles having a mean primary particle diameter of 12 nm and concentration of 20% by weight) (silica particles (b)) and 60 g of ethanol were placed in a 500 mL eggplant-shaped flask and stirred. Continuing, the Reaction Liquid 14 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 2.14 g (0.027 mol) of pyridine were then added to this polymer and mixed followed by dropping in 2.67 g (0.025 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 14.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 14 followed by stirring with a webbed rotor at room temperature until the added components dissolved to prepare a photosensitive silicon resin composition (P-16).

[Example 17]

25.76 g (0.111 mol) of MEDMO, 15.10 g (0.111 mol) of MTMS and 10 g of ethanol were placed in a 500 mL, eggplant-shaped flask and stirred. 19.96 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 15 containing the polysiloxane compound (a).

33.3 g of Snowtex 1PA-ST (Nissan Chemical Industries Co., Ltd., isopropyl alcohol-dispersed silica particles having a mean primary particle diameter of 10 nm to 20 nm and concentration of 30% by weight) (silica particles (b)) and 30 g of ethanol were placed in a 500 mL eggplant-shaped flask and stirred. Continuing, the Reaction Liquid 15 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 2.14 g (0.027 mol) of pyridine were then added to this polymer and mixed followed by dropping in 2.67 g (0.025 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 15.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 15 followed by stirring with a webbed rotor at room temperature until the added components dissolved to prepare a photosensitive silicon resin composition (P-17).

[Example 18]

16.62 g (0.071 mol) of MEDMO, 17.76 g (0.071 mol) of MEMO, 6.74 g (0.036 mol) of CYMDMS and 10 g of ethanol were placed in a 500 mL, eggplant-shaped flask and stirred. 15.44 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 16 containing the polysiloxane compound (a).

20 g of PL-1SL (silica particles (b)) and 40 g of ethanol were placed in a 500 mL eggplant-shaped flask and stirred. Continuing, the Reaction Liquid 16 cooled to room temperature was then dropped into the aforementioned eggplant-shaped flask over the course of 20 minutes using a dropping funnel and stirred for 30 minutes at room temperature.

Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 5.18 g (0.066 mol) of pyridine were then added to this polymer and mixed followed by dropping in 6.46 g (0.060 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 16.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 16 followed by stirring with a webbed rotor at room temperature until the added components dissolved to prepare a photosensitive silicon resin composition (P-18).

[Example 19]

24.18 g (0.104 mol) of MEDMO, 15.75 g (0.116 mol) of MTMS and 10 g of ethanol were placed in a 500 mL, eggplant-shaped flask and stirred. 19.98 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 17 containing the polysiloxane compound (a).

60 g of PL-1SL (silica particles (b)) and 40 g of ethanol were placed in a 500 mL eggplant-shaped flask and stirred. Continuing, the Reaction Liquid 17 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 1.01 g (0.013 mol) of pyridine were then added to this polymer and mixed followed by dropping in 1.25 g (0.116 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 17.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 17 followed by stirring with a webbed rotor at room temperature until the added components dissolved to prepare a photosensitive silicon resin composition (P-19).

[Example 20]

23.13 g (0.100 mol) of MEDMO, 3.01 g (0.022 mol) of MTMS and 10 g of ethanol were placed in a 500 mL, eggplant-shaped flask and stirred. 9.55 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 18 containing the polysiloxane compound (a).

60 g of PL-1SL (silica particles (b)) and 40 g of ethanol were placed in a 500 mL eggplant-shaped flask and stirred. Continuing, the Reaction Liquid 18 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.

After refluxing, 60 g of PGMEA were further added and a distillation column was attached followed by removal of the ethanol and water to obtain a PGMEA solution.

15 g of PGMEA, 25 g of toluene and 8.66 g (0.109 mol) of pyridine were then added to this polymer and mixed followed by dropping in 10.80 g (0.116 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 18.

10% by weight of tricyclodecane dimethanol diacrylate, photopolymerization initiator in the form of 0.5% by weight of 2,4,6-trimethylbenzoyl-diphenyl-phosphine oxide and 0.2% by weight of ethylenebis(oxyethylene)bis[3-(5-tert-butyl-4-hydroxy-m-tolyl)propionate] were added to 89.3% by weight of the resulting Polymer 18 followed by stirring with a webbed rotor at room temperature until the added components dissolved to prepare a photosensitive silicon resin composition (P-20).

[Example 21]

A photosensitive silicone resin composition (P-21) was prepared by adding 10% by weight of tricyclodecane dimethanol diacrylate, photopolymerization initiator in the form of 0.5% by weight of 2-hydroxy-2-methyl-1-phenylpropan-1-one (BASF SE, Darocure 1173), and 0.2% by weight of ethylenebis(oxyethylene) bis[3-(5-tert-butyl-4-hydroxy-m-tolyl) propionate] to 84.8% by weight of the Polymer 1 obtained in Example 1 and stirring with a webbed rotor at room temperature until the added components dissolved.

[Example 22]

A photosensitive silicone resin composition (P-22) was prepared by adding 10% by weight of 1,4-cyclohexane dimethanol monoacrylate, photopolymerization initiator in the form of 0.5% by weight of 2,4,6-trimethylbenzoyl-diphenyl-phosphine oxide, and 0.2% by weight of ethylenebis(oxyethylene)bis[3-(5- tert-butyl-4-hydroxy-m-tolyl)propionate] to 89.3% by weight of the Polymer 1 obtained in Example 1 and stirring with a webbed rotor at room temperature until the added components dissolved.

[Example 23]

A photosensitive silicone resin composition (P-23) was prepared by adding 10% by weight of epoxylated bisphenol A diacrylate (Shin-Nakamura Chemical Co., Ltd., A-BPE-10), photopolymerization initiator in the form of 0.5% by weight of 2,4,6-trimethylbenzoyl-diphenyl-phosphine oxide, and 0.2% by weight of ethylenebis(oxyethylene)bis[3-(5-tert-butyl-4- hydroxy-m-tolyl)propionate] to 89.3% by weight of the Polymer 1 obtained in Example 1 and stirring with a webbed rotor at room temperature until the added components dissolved.

[Example 24]

A photosensitive silicone resin composition (P-24) was prepared by adding 30% by weight of tricyclodecane dimethanol diacrylate, photopolymerization initiator in the form of 0.5% by weight of 2,4,6-trimethylbenzoyl-diphenyl-phosphine oxide, and 0.2% by weight of ethylenebis(oxyethylene)bis[3-(5- tert-butyl-4-hydroxy-m-tolyl)propionate] to 69.3% by weight of the Polymer 1 obtained in Example 1 and stirring with a webbed rotor at room temperature until the added components dissolved.

[Example 25]

A photosensitive silicone resin composition (P-25) was prepared by adding 50% by weight of tricyclodecane dimethanol diacrylate, photopolymerization initiator in the form of 0.5% by weight of 2,4,6-trimethylbenzoyl-diphenyl-phosphine oxide, and 0.2% by weight of ethylenebis(oxyethylene)bis[3-(5- tert-butyl-4-hydroxy-m-tolyl)propionate] to 49.3% by weight of the Polymer 3 obtained in Example 3 and stirring with a webbed rotor at room temperature until the added components dissolved.

[Example 26]

A photosensitive silicone resin composition (P-26) was prepared by adding 50% by weight of tricyclodecane dimethanol diacrylate, 20% by weight of ethoxylated bisphenol A diacrylate, photopolymerization initiator in the form of 0.5% by weight of 2,4,6-trimethylbenzoyl-diphenyl-phosphine oxide, and 0.2% by weight of ethylenebis(oxyethylene)bis [3-(5-tert-butyl-4- hydroxy-m-tolyl)propionate] to 29.3% by weight of the Polymer 3 obtained in Example 3 and stirring with a webbed rotor at room temperature until the added components dissolved.

[Example 27]

A photosensitive silicone resin composition (P-27) was prepared by adding photopolymerization initiator in the form of 0.5% by weight of 2,4,6-trimethylbenzoyl-diphenyl- phosphine oxide to 99.5% by weight of the Polymer 3 obtained in Example 3 and stirring with a webbed rotor at room temperature until the added components dissolved.

[Example 28]

A photosensitive silicone resin composition (P-28) was prepared by adding 70% by weight of tricyclodecane dimethanol diacrylate and photopolymerization initiator in the form of 0.5% by weight of 2,4,6-trimethylbenzoyl-diphenyl-phosphine oxide to 29.5% by weight of the Polymer 1 obtained in Example 1 and stirring with a webbed rotor at room temperature until the added components dissolved.

[Comparative Example 1]

34.35 g (0.148 mol) of MEDMO, 20.13 g (0.148 mol) of MTMS and 10 g of ethanol were placed in a 500 mL, eggplant-shaped flask and stirred. 26.61 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 19 containing the polysiloxane compound (a).
After refluxing, 60 g of PGMEA were further added and a distillation column was attached followed by removal of the ethanol and water to obtain a PGMEA solution.
15 g of PGMEA, 25 g of toluene and 2.86 g (0.036 mol) of pyridine were then added to this polymer and mixed followed by dropping in 3.56 g (0.033 mol) of TMCS (silicon compound (c)) over the course of 5 minutes while stirring. After stirring for 3 hours at room temperature, 10 g of water were added to the resulting reaction liquid and stirred, and extraction after adding 20 g of acetonitrile was repeated three times to wash the polymer. The solvent was then removed under reduced pressure using a vacuum pump to obtain a silica particle-containing condensation reaction product in the form of Polymer 19.
Photopolymerization initiator in the form of 0.5% by weight of 2,4,6-trimethylbenzoyl-diphenyl-phosphine oxide was added to 99.5% by weight of the resulting Polymer 19 followed by stirring with a webbed rotor at room temperature until the added component dissolved to prepare a photosensitive silicon resin composition (P-29).

[Comparative Example 2]

27.60 g (0.119 mol) of MEDMO, 16.18 g (0.119 mol) of MTMS and 10 g of ethanol were placed in a 500 mL, eggplant-shaped flask and stirred. 21.38 g of distilled water and 0.004 g of 10% hydrochloric acid were placed in a separate container and after mixing, the mixture was dropped into the aforementioned 500 mL eggplant-shaped flask over the course of 10 minutes using a dropping funnel. Following completion of dropping, a cooling tube was attached and the contents were refluxed for 2 hours at 80°C in the presence of flowing nitrogen using an oil bath to obtain Reaction Liquid 20 containing the polysiloxane compound (a).
50 g of PL-1SL (silica particles (b)) and 50 g of ethanol were placed in a 500 mL eggplant-shaped flask and stirred. Continuing, the Reaction Liquid 20 cooled to room temperature was then dropped into the aforementioned eggplant-shaped flask over the course of 20 minutes using a dropping funnel and stirred for 30 minutes at room temperature. Following stirring, a cooling tube was attached and the contents were refluxed for 4 hours at 80°C in the presence of flowing nitrogen.
After refluxing, 60 g of PGMEA were further added and a distillation column was attached followed by removal of the ethanol and water to obtain a PGMEA solution. The solvent was then removed under reduced pressure using a vacuum pump to obtain a silica particle-containing condensation reaction product in the form of Polymer 20.
Photopolymerization initiator in the form of 0.5% by weight of 2,4,6-trimethylbenzoyl-diphenyl-phosphine oxide was added to 99.5% by weight of the resulting Polymer 20 followed by stirring with a webbed rotor at room temperature until the added component dissolved to prepare a photosensitive silicon resin composition (P-30).

<Fabrication of Cured Molded Product>

Five drops of the resulting photosensitive resin composition (P-1) were dropped onto the center of alkali-free glass (thickness: 0.7 mm, dimensions: 5 cm x 10 cm, Corning Inc.) surface-treated with a mold release agent composed of a fluorine compound using a dropper. At this time, two polycarbonate films (thickness: 1 mm, dimensions: 0.5 cm x 5 cm) were placed on both sides of the alkali-free glass, another piece of alkali-free glass surface-treated with a mold release agent composed of a fluorine compound was further fixed on the photosensitive resin composition, and the photosensitive resin composition dropped onto the first piece of alkali-free glass was sandwiched between the two pieces of alkali-free glass to create an anaerobic state that allows inhibition of curing by oxygen to be ignored. Subsequently, the alkali-free glass on one side was irradiated with ultraviolet light at an intensity of 3000 mJ/cm$^2$ using a metal halide lamp (Fusion UV Systems Japan K.K., CV-110Q-G, dominant wavelength: approx. 380 nm) to fabricate a cured molded product having a film thickness of 1 mm designated as Cured Molded Product 1-1.

Cured molded products were fabricated using the same method as described above for photosensitive silicon resin compositions (P-2) to (P-30), and were respectively designated as Cured Molded Products 2-1 to 30-1.

[Fabrication of Cured Film]

One drop of the resulting photosensitive resin composition (P-1) was dropped onto the center of alkali-free glass (thickness: 0.7 mm, dimensions: 5 cm x 10 cm, Corning Inc.) surface-treated with a mold release agent composed of a fluorine compound using a dropper. At this time, two polyethylene terephthalate films (thickness: 50 $\mu$m, dimensions: 0.5 cm x 5 cm) were placed on both sides of the alkali-free glass, another piece of alkali-free glass surface-treated with a mold release agent composed of a fluorine compound was further fixed on the photosensitive resin composition, and the photosensitive resin composition dropped onto the first piece of alkali-free glass was sandwiched between the two pieces of alkali-free glass to create an anaerobic state that allows inhibition of curing by oxygen to be ignored. Subsequently, the alkali-free glass on one side was irradiated with ultraviolet light at an intensity of 3000 mJ/cm$^2$ using a metal halide lamp (Fusion UV Systems Japan K.K., CV-110Q-G, dominant wavelength: approx. 380 nm) to fabricate a cured film having a film thickness of 50 $\mu$m designated as Cured Film 1-2.

Cured films were fabricated using the same method as described above for photosensitive silicon resin compositions (P-2) to (P-30), and were respectively designated as Cured Films 2-2 to 30-2.

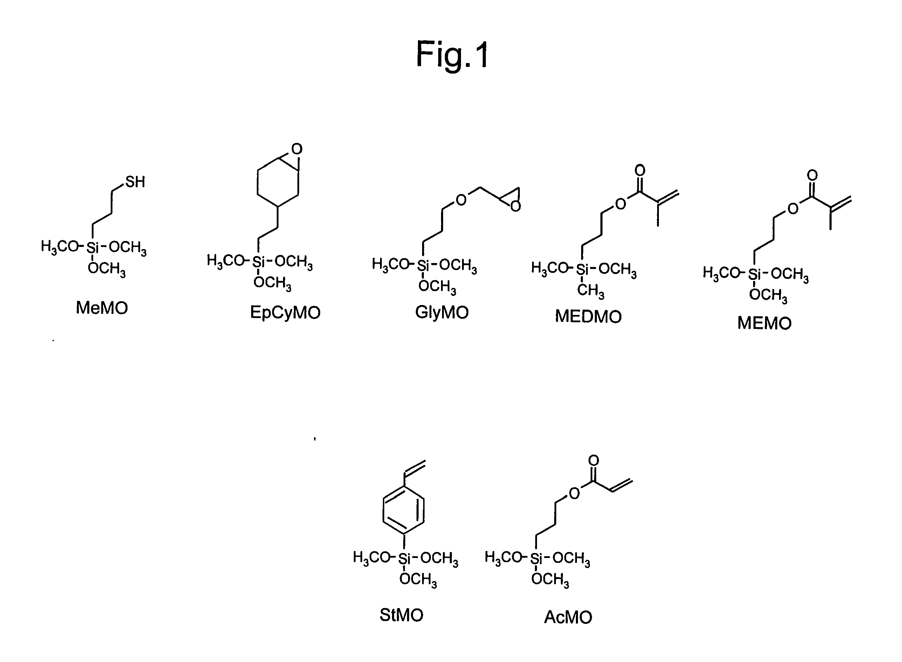

Structural formulas of the silane compounds used to synthesize the silica particle-containing condensation reaction product (A) are shown in FIG. 1.

Mole percentages during charging of Polymers 1 to 21 are shown in the following Table 1.

[Table 1]

Table 1

| Polymer No. | Sol-gel reaction portion/mol% | | | | | | | | | | | Silica particles (b)/wt% | | | | $(Si\text{-}O\text{-}SiR^3_3]/($ $[Si\text{-}O\text{-}R^2] + [Si\text{-}O\text{-}SiR^3_3])$ |
| | Polysiloxane compound (a) | | | | | | | | Silicon compound (c) | | | | | | | |
| | MEDMO | MEMO | AcMO | StMO | GlyMO | EpCyMO | MeMO | CyMDMS | MTMS | TMCS | HDMS | PL-1SL | PL-06 | BS-1 | 1PA-ST | |
| 1 | 45 | | | | | | | | 45 | 10 | | 25 | | | | 0.47 |
| 2 | 45 | | | | | | | | 45 | 10 | | 55 | | | | 0.44 |
| 3 | 25 | 30 | | | | | | 35 | | 10 | | 60 | | | | 0.35 |
| 4 | 30 | | 30 | | | | | | 15 | 25 | | 30 | | | | 0.1 |
| 5 | 30 | | | 30 | | | | | 15 | 25 | | 30 | | | | 0.52 |
| 6 | 45 | | | | 15 | | | 15 | | 25 | | 30 | | | | 0.63 |
| 7 | 45 | | | | | 15 | | 15 | | 25 | | 30 | | | | 0.64 |
| 8 | 45 | | | | | | 30 | 15 | | 10 | | 30 | | | | 0.37 |
| 9 | | | 30 | | | | | | 45 | 25 | | 30 | | | | 0.75 |
| 10 | | | | 30 | | | | | 45 | 25 | | 30 | | | | 0.38 |
| 11 | | | | | | | 30 | | 45 | 25 | | 30 | | | | 0.83 |
| 12 | 30 | | 30 | | | | | 15 | | | 15 | 30 | | | | 0.45 |
| 13 | 45 | | | | | | | | 40 | 15 | | | 30 | | | 0.53 |
| 14 | 45 | | | | | | | | 45 | 10 | | | | 25 | | 0.26 |
| 15 | 45 | | | | | | | | 45 | 10 | | | | | 25 | 0.43 |
| 16 | 30 | 30 | | | | | | 15 | | 25 | | 10 | | | | 0.67 |
| 17 | 45 | | | | | | | | 50 | 5 | | 30 | | | | 0.53 |
| 18 | 45 | | | | | | | | 10 | 45 | | 30 | | | | 0.47 |
| 19 | 45 | | | | | | | | 45 | 10 | | | | | | 0.36 |
| 20 | 50 | | | | | | | | 50 | | | 25 | | | | 0 |

The weight percentages and photopolymerizable functional group equivalents of the components of the photosensitive silicone resin compositions of (P-1) to (P-30) are shown in the following Table 2.
[Table 2]

Table 2

| Photosensitive silicone resin composition | Silica particle-containing condensation reaction product (A) | wt% | Photopolymerization initiator (B) | wt% | Compound (C) having a photopolymerizable functional group in a molecule thereof | wt% | Antioxidant and/or ultraviolet absorber (D) | wt% | Photopolymerizable functional group equivalent mmol/g |
|---|---|---|---|---|---|---|---|---|---|
| P-1 | Polymer-1 | 94.3 | Lucirin TPO | 0.5 | Tricyclodecane dimethanol diacrylate | 5 | Irganox 245 | 0.2 | 2.94 |
| P-2 | Polymer-2 | 77.3 | Lucirin TPO | 0.5 | Tricyclodecane dimethanol diacrylate | 22 | Irganox 245 | 0.2 | 2.73 |
| P-3 | Polymer-3 | 59.3 | Lucirin TPO | 0.5 | Tricyclodecane dimethanol diacrylate | 40 | Irganox 245 | 0.2 | 3.46 |
| P-4 | Polymer-1 | 99.5 | Lucirin TPO | 0.5 | | | | | 2.75 |
| P-5 | Polymer-1 | 89.5 | Lucirin TPO | 0.5 | Tricyclodecane dimethanol diacrylate | 10 | | | 3.13 |
| P-6 | Polymer-4 | 89.3 | Lucirin TPO | 0.5 | Tricyclodecane dimethanol diacrylate | 10 | Irganox 245 | 0.2 | 3.42 |
| P-7 | Polymer-5 | 89.3 | Lucirin TPO | 0.5 | Tricyclodecane dimethanol diacrylate | 10 | Irganox 245 | 0.2 | 3.49 |
| P-8 | Polymer-6 | 88.8 | Lucirin TPO / Irgacure 250 | 0.5 / 0.5 | Tricyclodecane dimethanol diacrylate | 10 | Irganox 245 | 0.2 | 3.16 |
| P-9 | Polymer-7 | 88.8 | Lucirin TPO / Irgacure 250 | 0.5 / 0.5 | Tricyclodecane dimethanol diacrylate | 10 | Irganox 245 | 0.2 | 3.13 |
| P-10 | Polymer-8 | 89.3 | Lucirin TPO | 0.5 | Tricyclodecane dimethanol diacrylate | 10 | Irganox 245 | 0.2 | 3.76 |
| P-11 | Polymer-9 | 89.3 | Lucirin TPO | 0.5 | Tricyclodecane dimethanol diacrylate | 10 | Irganox 245 | 0.2 | 2.53 |
| P-12 | Polymer-10 | 89.3 | Lucirin TPO | 0.5 | Tricyclodecane dimethanol diacrylate | 10 | Irganox 245 | 0.2 | 2.59 |
| P-13 | Polymer-11 | 89.3 | Lucirin TPO | 0.5 | Tricyclodecane dimethanol diacrylate | 10 | Irganox 245 | 0.2 | 2.77 |

| Photosensitive silicone resin composition | Silica particle-containing condensation reaction product (A) | wt% | Photopolymerization initiator (B) | wt% | Compound (C) having a photopolymerizable functional group in a molecule thereof | wt% | Antioxidant and/or ultraviolet absorber (D) | wt% | Photopolymer-izable functional group equivalent mmol/g |
|---|---|---|---|---|---|---|---|---|---|
| P-14 | Polymer-12 | 89.3 | Lucirin TPO | 0.5 | Tricyclodecane dimethanol diacrylate | 10 | Irganox 245 | 0.2 | 3.21 |
| P-15 | Polymer-13 | 89.3 | Lucirin TPO | 0.5 | Tricyclodecane dimethanol diacrylate | 10 | Irganox 245 | 0.2 | 2.95 |
| P-16 | Polymer-14 | 89.3 | Lucirin TPO | 0.5 | Tricyclodecane dimethanol diacrylate | 10 | Irganox 245 | 0.2 | 3.13 |
| P-17 | Polymer-15 | 89.3 | Lucirin TPO | 0.5 | Tricyclodecane dimethanol diacrylate | 10 | Irganox 245 | 0.2 | 3.13 |
| P-18 | Polymer-16 | 89.3 | Lucirin TPO | 0.5 | Tricyclodecane dimethanol diacrylate | 10 | Irganox 245 | 0.2 | 3.85 |
| P-19 | Polymer-17 | 89.3 | Lucirin TPO | 0.5 | Tricyclodecane dimethanol diacrylate | 10 | Irganox 245 | 0.2 | 2.98 |
| P-20 | Polymer-18 | 89.3 | Lucirin TPO | 0.5 | Tricyclodecane dimethanol diacrylate | 10 | Irganox 245 | 0.2 | 2.88 |
| P-21 | Polymer-1 | 84.8 | Darocure 1173 | 5 | Tricyclodecane dimethanol diacrylate | 10 | Irganox 245 | 0.2 | 2.99 |
| P-22 | Polymer-1 | 89.3 | Lucirin TPO | 0.5 | 1,4-cyclohexane monodimethanol monoalkylate | 10 | Irganox 245 | 0.2 | 2.98 |
| P-23 | Polymer-1 | 89.3 | Lucirin TPO | 0.5 | Ethoxylated bisphenol A diacrylate | 10 | Irganox 245 | 0.2 | 2.73 |
| P-24 | Polymer-1 | 69.3 | Lucirin TPO | 0.5 | Tricyclodecane dimethanol diacrylate | 30 | Irganox 245 | 0.2 | 3.89 |
| P-25 | Polymer-3 | 49.3 | Lucirin TPO | 0.5 | Tricyclodecane dimethanol diacrylate | 50 | Irganox 245 | 0.2 | 3.98 |
| P-26 | Polymer-3 | 29.3 | Lucirin TPO | 0.5 | Tricyclodecane dimethanol diacrylate | 50 | Irganox 245 | 0.2 | 4.21 |

(continued)

| Photosensitive silicone resin composition | Silica particle-containing condensation reaction product (A) | wt% | Photopolymerization initiator (B) | wt% | Compound (C) having a photopolymerizable functional group in a molecule thereof | wt% | Antioxidant and/or ultraviolet absorber (D) | wt% | Photopolymer-izable functional group equivalent mmol/g |
|---|---|---|---|---|---|---|---|---|---|
| | | | | | Ethoxylated bisphenol A diacrylate | 20 | | | |
| P-27 | Polymer-3 | 99.5 | Lucirin TPO | 0.5 | | | Irganox 245 | 0.2 | 1.39 |
| P-28 | Polymer-1 | 29.5 | Lucirin TPO | 0.5 | Tricyclodecane dimethanol diacrylate | 70 | Irganox 245 | 0.2 | 5.42 |
| P-29 | Polymer-19 | 99.5 | Lucirin TPO | 0.5 | | | Irganox 245 | 0.2 | 3.70 |
| P-30 | Polarmer-20 | 99.5 | Lucirin TPO | 0.5 | | | Irganox 245 | 0.2 | 2.97 |

The results of carrying out measurements and evaluations in accordance with (1) to (5) below on samples of the Cured Molded Products 1-1 to 30-1 and the Cured Films 1-2 to 30-2 fabricated using the photosensitive silicone resin compositions (P-1) to (P-30) fabricated in Examples 1 to 28 and Comparative Examples 1 and 2 are shown in the following Table 3.

Since Comparative Example 1 does not contain silica particles (b), thermal shrinkage and coefficient of linear thermal expansion were inferior, and since the value of $[Si-O-SiR^33]/([Si-O-R^2] + [Si-O-SiR^3_3])$, representing the terminal structure of the condensation product (A), is 0 in Comparative Example 2, the rate of thermal weight loss was inferior.

[Table 3]

Table 3

| | Photosensitive silicone resin composition | Shrinkage Evaluation | | (3) Crack Resistance Evaluation | (4) Measurement of Coefficient of Linear Thermal Expansion | (5) Thermal Weight Loss Evaluation |
|---|---|---|---|---|---|---|
| | | (2) Heat | (6) Light | | | |
| Example 1 | P-1 | A | A | A | A | A |
| Example 2 | P-2 | A | A | A | A | A |
| Example 3 | P-3 | A | A | A | A | A |
| Example 4 | P-4 | A | A | A | A | A |
| Example 5 | P-5 | A | A | A | A | A |
| Example 6 | P-6 | A | A | A | A | A |
| Example 7 | P-7 | A | A | A | A | A |
| Example 8 | P-8 | A | A | A | A | A |
| Example 9 | P-9 | A | A | A | A | A |
| Example 10 | P-10 | A | A | A | A | A |
| Example 11 | P-11 | A | A | A | A | A |
| Example 12 | P-12 | A | A | A | A | A |
| Example 13 | P-13 | A | A | A | A | A |
| Example 14 | P-14 | A | A | A | A | A |
| Example 15 | P-15 | A | A | A | A | A |
| Example 16 | P-16 | A | A | A | A | A |
| Example 17 | P-17 | A | A | A | A | A |
| Example 18 | P-18 | A | A | A | A | A |
| Example 19 | P-19 | A | A | A | A | A |
| Example 20 | P-20 | A | A | A | A | A |
| Example 21 | P-21 | A | A | A | A | A |
| Example 22 | P-22 | A | A | A | A | A |
| Example 23 | P-23 | A | A | A | A | A |
| Example 24 | P-24 | A | A | A | A | A |
| Example 25 | P-25 | A | A | A | A | A |
| Example 26 | P-26 | A | B | A | A | A |
| Example 27 | P-27 | A | A | B | B | B |
| Example 28 | P-28 | A | B | A | A | A |

(continued)

| | Photosensitive silicone resin composition | Shrinkage Evaluation | | (3) Crack Resistance Evaluation | (4) Measurement of Coefficient of Linear Thermal Expansion | (5) Thermal Weight Loss Evaluation |
|---|---|---|---|---|---|---|
| | | (2) Heat | (6) Light | | | |
| Comparative Example 1 | P-29 | C | A | A | C | A |
| Comparative Example 2 | P-30 | B | A | B | A | C |

(1) $^{29}$Si-NMR Measurement of Silica Particle-Containing

Condensation Reaction Products

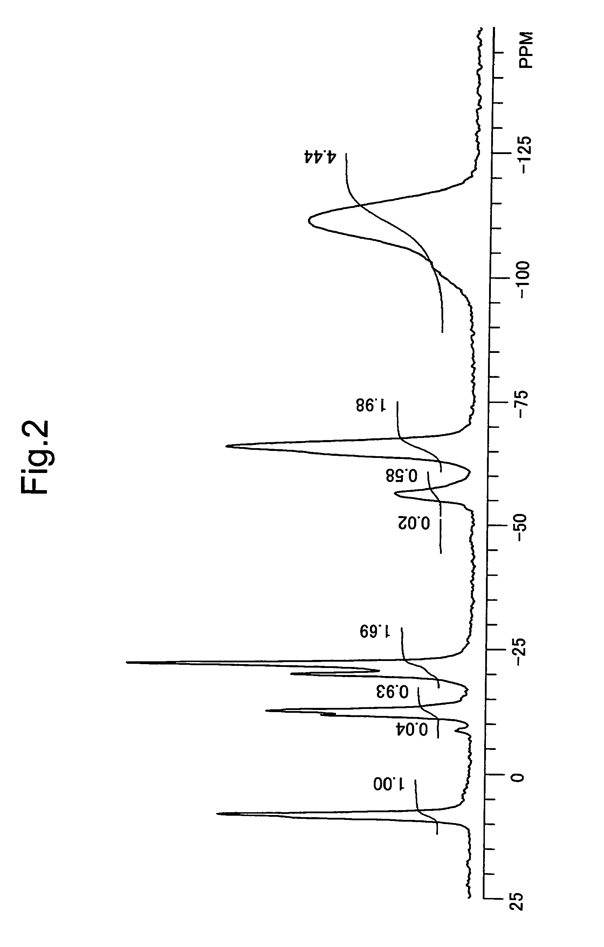

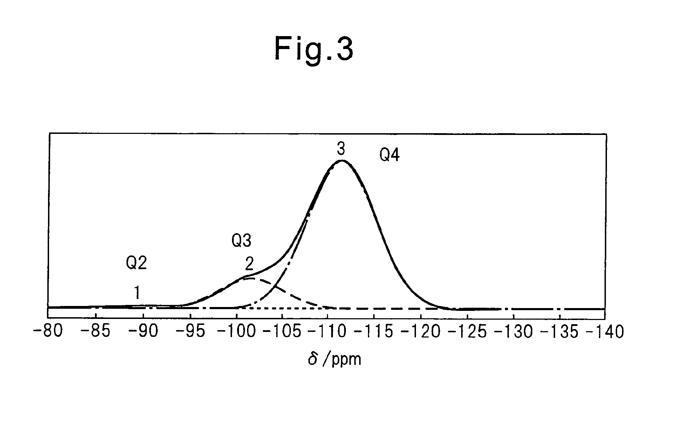

0.6% by weight of chromium acetyl acetonate were added to a deuterated chloroform solution of 30% by weight of Polymer 1 to prepare a sample followed by measurement with an NMR (nuclear magnetic resonance) system (JEOL Ltd., Model ECA700) using an SI10 probe at an observation frequency of 139.1 MHz with no spin and using a waiting time of 120 seconds and cumulative number of measurement cycles of 200 cycles. The progress of the reaction was confirmed from the peaks of component T3, component T2, component D2 and component D1.
The results of $^{29}$Si-NMR for Polymer 1 are shown in FIG. 2.
In addition, the results of waveform separation for component Q are shown in FIG. 3. Waveform separation was carried out by calculating peak separation of the silica particles (b) according to the non-linear least square method using the Lorentzian function, and then calculating in the same manner using the half width value thereof. As a result of waveform separation, the ratios of component Q2, component Q3 and component Q4 were 1.5%, 15.5% and 83.0%. Component Q4 having a peak of -111 ppm derived from the particles, component Q3 having a peak of -102 ppm derived from the particles, component Q2 having a peak of -89 ppm derived from the particles, a peak at - 72 ppm derived from component T3, a peak at -57 ppm derived from component T2, a peak at -17 to -25 ppm derived from component D2, a peak at -10 ppm to -15 ppm derived from component D1, and a peak at 9 ppm derived from component M1 were able to be assigned. The condensation ratio of Polymer 1 as determined according to the following formula using the integrated values of each peak was 93%.
In the following, the peak area of component D1, for example, is represented as (D1).

Condensed silicon area:

$$\{(M1)+ (D1) + (D2) \times 2 + (T1) + (T2) \times 2 + (T3) \times 3 + (Q1) + (Q2) \times 2 + (Q3) \times 3 + (Q4) \times 4\}$$

Total silicon area:

$$\{(M0) + (M1)\} + \{(D0) + (D1) + (D2)\} \times 2 + \{(T0) + (T1) + (T2) + (T3)\} \times 3 + \{(Q0) + (Q1) + (Q2) + (Q3) + (Q4)\} \times 4$$

$$\text{Condensation ratio} = \text{(condensed silicon area)/(total silicon area)} \times 100$$

In addition, the results of determining the value of the following formula:

$$[\text{Si-O-SiR}^3_3]/([\text{Si-O-R}^2] + [\text{Si-O-SiR}^3_3])$$

wherein [Si-O-S1R$^3_3$] represents (M1) and [Si-O-R$^2$] represents the sum of twice the value of (D1) and (T1), three times the value of (T2) and (Q1), twice the value of (Q2) and the value of (Q3), are shown in Table 2.

(2) Evaluation of Thermal Shrinkage

Film thicknesses were measured for the fabricated Cured Molded Products 1-1 to 30-1, and after baking under conditions of 3 hours at 150°C in a nitrogen atmosphere, film thicknesses were again measured for the Cured Molded Products 1-1 to 30-1. A film thickness after baking based on a value of 100% for the film thickness before baking under conditions of 3 hours at 150°C in a nitrogen atmosphere of 99% or more was evaluated with a "A", that of 98% to less than 99% with a "B", and that of less than 98% with an "C".

(3) Evaluation of Crack Resistance

The fabricated Cured Molded Products 1-1 to 30-1 were baked under conditions of 3 hours at 150°C in a nitrogen atmosphere and observed at 5 locations, those for which there were no cracks at any of the 5 locations were evaluated with a "A", those for which there were cracks at 1 to 4 locations were evaluated with a "B", and those for which there were cracks at all 5 locations were evaluated with an "C".

(4) Measurement of Coefficient of Linear Thermal Expansion

The fabricated Cured Films 1-2 to 30-2 were cut out to a width of 3 mm followed by measuring using the TMA-60 manufactured by Shimadzu Corp. according to the tensile measurement method under conditions of a sample length of 15 mm, load of 5.0 g and heating rate of 10°C/min, and using values obtained by measuring a second time using the same samples. Mean expansion was calculated from 30°C to 70°C, and a value of less than 50 ppm/°C was evaluated with a "A", a value of 50 ppm/°C to less than 70 ppm/°C was evaluated with a "B", and a value of 70 ppm/°C or greater was evaluated with an "C".

(5) Evaluation of Thermal Weight Loss

The weights of the fabricated Cured Molded Products 1-1 to 30-1 were measured, and after baking under conditions of 3 hours at 150°C in a nitrogen atmosphere, the weights of the Cured Molded Products 1-1 to 30-1 were measured again. The weight after baking was calculated as a percentage based on a value of 100% for the weight before baking under conditions of 3 hours at 150°C in a nitrogen atmosphere, and a value of 99% or more was evaluated with a "A", a value of 98% to less than 99% was evaluated with a "B", and a value of less than 98% was evaluated with an "C".

(6) Evaluation of Photoshrinkage

Densities of the photosensitive silicone resin compositions of (P-1) to (P-3) and (P-28) and densities of Cured Molded Products 1-1 to 3-1 and 28-1 were measured at 22°C using a Hubbard-type pycnometer. Volumetric shrinkage factor attributable to photocuring was calculated from the density of the photosensitive silicone resin compositions before photocuring and the density of the cured molded products after curing. A volumetric shrinkage factor of 5.0% or less was evaluated with a "A", a volumetric shrinkage factor of greater than 5.0% to 6.0% or less was evaluated with a "B", and a volumetric shrinkage factor of greater than 6.0% was evaluated with an "C".

(7) Evaluation of Visible-UV Region Transmittance

Transmittance of the fabricated Cured Molded Products 1-1 to 3-1 was measured using the UV3101PC manufactured by Shimadzu Corp. at a slit width of 5.0 nm. Transmittance at a wavelength of 400 nm was 88% in each case.

(8) Evaluation of Hardness

The Shore D hardness of the fabricated Cured Molded Products 1-1 to 3-1 and 29-1 was measured using a Teclock Durometer (TeClock Corp., Model GS-702N Type D). The hardness values of the Cured Molded Products 1-1 to 3-1 and 29-1 were 80, 86, 85 and 60, respectively, and the hardness of Cured Molded Product 29-1 not containing the silica particles (b) was determined to be lower.

(9) Evaluation of Water Absorption

The fabricated Cured Molded Products 1-1, 16-1 and 30-1 were immersed in distilled water for 24 hours followed by measurement of their weights. The weights of the sample were then measured again after drying for 2 hours at 120°C. The increase in weight after immersing based on a value of 100% for the weight after drying was calculated as the water absorption rate. The water absorption rates of the Cured Molded Products 1-1, 16-1 and 30-1 were 1.5%, 1.1% and 3.0%, respectively, and the water absorption rate of Cured Molded Product 30-1, for which the value of $[Si\text{-}O\text{-}SiR^3_3]/($ $[Si\text{-}O\text{-}R^2] + [Si\text{-}O\text{-}SiR^3_3])$ is 0 was greater than that of the other cured molded products.

(10) Measurement of Molecular Weight of Silica Particle-

Containing Condensation Reaction Product

Gel permeation chromatography (GPC) was carried out using the GPC Max, TDA305 and TSKgel GMHHR-M column manufactured by Viscotek Corp. The sample consisted of preparing a 1% by weight solution of Polymer 1 in tetrahydrofuran solvent, and weight average molecular weight (Mw) using polymethacrylate for the standard was determined with a differential refractometer (RI). The molecular weight was 2325.

<u>INDUSTRIAL APPLICABILITY</u>

An optical material obtained by using the resin composition of the present invention can be preferably used as various types of plastic lens materials used in, for example, the plastic lens of cell phones, LEDs or vehicles and the like, replica materials, backlighting optical sheets of liquid crystal displays and the like, lighting, various types of sensors, printers and copying machines.

**Claims**

1. A photosensitive silicone resin composition comprising (A) a silica particle-containing condensation reaction product and (B) a photopolymerization initiator, wherein:

   the silica particle-containing condensation reaction product (A) is a condensation reaction product of polysiloxane compound (a), composed of a hydrolytic condensation product of one or more types of silane compounds represented by the following general formula (1):

   $R^1_{n1}SiX^1_{4-n1}$     (1)

   (wherein, $R^1$ represents a hydrogen atom or organic group containing 1 to 20 carbon atoms, n1 represents an integer of 0 to 3, $X^1$ represents a group selected from the group consisting of a hydroxyl group, halogen atom, alkoxy group having 1 to 6 carbon atoms and acetoxy group having 1 to 6 carbon atoms, and n1, $R^1$ and $X^1$ may each be the same or different in the case a plurality thereof is present) and/or the silane compound, and silica particles (b), a terminal structure Si-O-Y of the condensation reaction product (A) (wherein, Y represents $R^2$ or $SiR^3_3$, $R^2$ and $R^3$ represent hydrogen atoms or organic groups having 1 to 20 carbon atoms, and the plurality of $R^3$ may each be the same or different) satisfies the following formula (2):

   $0 < [Si\text{-}O\text{-}SiR^3_3]/([Si\text{-}O\text{-}R^2] + [Si\text{-}O\text{-}SiR^3_2]) \leq 1$     (2)

(wherein, $R^2$ and $R^3$ are as previously described), and the condensation reaction product (A) has a photopolymerizable functional group.

2. The photosensitive silicone resin composition according to claim 1, wherein the photopolymerizable functional group equivalent of the photosensitive silicone resin composition is 0.5 mmol/g to 4.5 mmol/g.

3. The photosensitive silicone resin composition according to claim 1, wherein the [Si-O-SiR$^3_3$] in formula (2) is derived from one or more types of a silicon compound (c) represented by the following general formula (3) :

$$R^3_3SiX^2 \quad (3)$$

(wherein, $R^3$ is the same as defined in formula (2), $X^2$ represents a group selected from the group consisting of a hydroxyl group, halogen atom, alkoxy group having 1 to 6 carbon atoms and acetoxy group having 1 to 6 carbon atoms, and the plurality of $R^3$ present may be the same or different), or the following general formula (4):

$$R^3_3SiNHSiR^3_3 \quad (4)$$

(wherein, $R^3$ is the same as defined in formula (2), and the plurality of $R^3$ present may be the same or different).

4. The photosensitive silicone resin composition according to claim 1, wherein the silica particle-containing condensation reaction product (A) is a condensation reaction product of the polysiloxane compound (a) composed of a hydrolytic condensation product of one or more types of silane compounds represented by general formula (1), or the polysiloxane compound (a) and the silane compound, and the silica particles (b).

5. The photosensitive silicone resin composition according to claim 1, wherein the [Si-O-SiR$^3_3$] in formula (2) is obtained by reacting a condensation reaction product of the polysiloxane compound (a) and/or the silane compound and the silica particles (b), with the silicon compound (c).

6. The photosensitive silicone resin composition according to claim 1, further comprising a compound (C) having a photopolymerizable functional group in a molecule thereof.

7. The photosensitive silicone resin composition according to claim 1, further comprising (D) an antioxidant and/or ultraviolet absorber.

8. The photosensitive silicone resin composition according to claim 7, comprising 100 parts by weight of the silica particle-containing condensation reaction product (A), 0.01 parts by weight to 50 parts by weight of the photopolymerization initiator (B), 0 parts by weight to 900 parts by weight of the compound (C) having a photopolymerizable function group in a molecule thereof, and 0 parts by weight to 50 parts by weight of the antioxidant and/or ultraviolet absorber (D).

9. The photosensitive silicone resin composition according to claim 3, wherein the photopolymerizable function group in the silica particle-containing condensation reaction product (A) is derived from the polysiloxane compound (a) and/or the silicon compound (c).

10. The photosensitive silicone resin composition according to claim 6, wherein the photopolymerizable functional group in the silica particle-containing condensation reaction product (A) and/or the compound (C) having a photopolymerizable functional group in a molecule thereof is at least one type selected from the group consisting of a (meth) acryloyl group, styryl group, norborneyl group, epoxy group and mercapto group.

11. The photosensitive silicone resin composition according to claim 3, wherein the amount of the silica particles (b) in 100% by weight of the silica particle-containing condensation reaction product (A) is 1% by weight to 80% by weight, and the total amount of the polysiloxane compound (a) and the silicon compound (c) is 20% by weight to 99% by weight.

12. The photosensitive silicone resin composition according to claim 1, wherein the molar ratio (component M/(component M + component D + component T + component Q)} x 100 of a component M to the total number of moles of the component M, a component D, a component T and a component Q in the silica particle-containing condensation reaction product (A) excluding the silica particles (b) is 1 mol% to 50 mol%.

13. The photosensitive silicone resin composition according to claim 1, wherein the polysiloxane compound (a) contains a product obtained as a hydrolytic condensation product of a silane compound in which at least n1 of the silane compound represented by general formula (1) is 1.

14. The photosensitive silicone resin composition according to claim 1, wherein the polysiloxane compound (a) contains a product obtained as a hydrolytic condensation product of a silane compound in which at least n1 in the silane compound represented by general formula (1) is 1, and a silane compound in which n1 is 2.

15. The photosensitive silicone resin composition according to claim 1, the ratio of the number of bonds that form siloxane bonds with silicon in the silica particle-containing condensation reaction product (A) to the total number of bonds that respectively form the siloxane bonds, direct bonds with hydroxyl groups and direct bonds with hydrolyzable groups is 40 mol% to 100 mol%.

16. The photosensitive silicone resin composition according to claim 1, wherein the silica particles (b) are produced from an alkoxysilane by a wet method.

17. The photosensitive silicone resin composition according to claim 1, wherein the mean primary particle diameter of the silica particles (b) is 1 nm to 20 nm.

18. The photosensitive silicone resin composition according to claim 3, wherein the silicon compound (c) is a silicon compound in which $X^2$ in the silicon compound represented by general formula (3) is a halogen atom.

19. The photosensitive silicone resin composition according to claim 6, wherein the photopolymerizable functional group in the silica particle-containing condensation reaction product (A) and/or the compound (C) having a photopolymerizable functional group in a molecule thereof is a (meth)acryloyl group and/or styryl group.

20. The photosensitive silicone resin composition according to claim 6, wherein the photopolymerizable functional group in the silica particle-containing condensation reaction product (A) and/or the compound (C) having a photopolymerizable functional group in a molecule thereof is an epoxy group and/or mercapto group.

21. The photosensitive silicone resin composition according to claim 1, wherein the photopolymerization initiator (B) is a photoradical polymerization initiator.

22. The photosensitive silicone resin composition according to claim 6, wherein at least one type of the compound (C) having a photopolymerizable functional group in a molecule thereof contains one or more carbon rings and/or heterocycles in a molecule thereof.

23. A production process of a photosensitive silicone resin composition, comprising the following steps:

a first step for obtaining a polysiloxane compound (a) by hydrolytically condensing one or more types of silane compounds represented by the following general formula (1):

$$R^1{}_{n1}SiX^1{}_{4-n1} \quad (1)$$

(wherein, $R^1$ represents a hydrogen atom or organic group containing 1 to 20 carbon atoms, n1 represents an integer of 0 to 3, $X^1$ represents a group selected from the group consisting of a halogen atom, alkoxy group having 1 to 6 carbon atoms and acetoxy group having 1 to 6 carbon atoms, and n1, $R^1$ and $X^1$ may each be the same or different in the case a plurality thereof is present),
a second step for obtaining a condensation reaction product by condensing the resulting polysiloxane compound (a) and/or the silane compound with silica particles (b),
a third step for obtaining a silica particle-containing condensation reaction product (A) by condensing the resulting condensation reaction product with a silicon compound (c) represented by the following general formula (3):

$$R^3{}_3SiX^2 \quad (3)$$

(wherein, $R^3$ represents a hydrogen atom or organic group containing 1 to 20 carbon atoms, $X^2$ represents a

group selected from the group consisting of a hydroxyl group, halogen atom, alkoxy group having 1 to 6 carbon atoms and acetoxy group having 1 to 6 carbon atoms, and the plurality of $R^3$ present may be the same or different), or the following general formula (4):

$$R^3_3SiNHSiR^3_3 \quad (4)$$

(wherein, $R^3$ is the same as defined in general formula (3)), and
a fourth step for mixing the resulting silica particle- containing condensation reaction product (A) with a photopolymerization initiator (B).

24. A production process of a photosensitive silicone resin composition, comprising the following steps:

a first step for obtaining a polysiloxane compound (a) by hydrolytically condensing a silane compound at least including a silane compound represented by the following general formula (1):

$$R^1_{n1}SiX^1_{4-n1} \quad (1)$$

(wherein, $R^1$ represents a hydrogen atom or organic group containing 1 to 20 carbon atoms, n1 represents an integer of 0 to 3, $X^1$ represents a group selected from the group consisting of a hydroxyl group, halogen atom, alkoxy group having 1 to 6 carbon atoms and acetoxy group having 1 to 6 carbon atoms, and n1, $R^1$ and $X^1$ may each be the same or different in the case a plurality thereof is present) in which n1 is 3,
a second step for obtaining a condensation reaction product by condensing the resulting polysiloxane compound (a) and/or the silane compound with silica particles (b),
a third step for obtaining a silica particle-containing condensation reaction product (A) by condensing the resulting condensation reaction product at with a silane compound at least including a silane compound represented by the following general formula (1) :

$$R^1_{n1}SiX^1_{4-n1} \quad (1)$$

(wherein, $R^1$ represents a hydrogen atom or organic group containing 1 to 20 carbon atoms, n1 represents an integer of 0 to 3, $X^1$ represents a group selected from the group consisting of a hydroxyl group, halogen atom, alkoxy group having 1 to 6 carbon atoms and acetoxy group having 1 to 6 carbon atoms, and n1, $R^1$ and $X^1$ may each be the same or different in the case a plurality thereof is present) in which n1 is 1 or 2, and
a fourth step for mixing the resulting silica particle- containing condensation reaction product (A) with a photopolymerization initiator (B).

25. The process according to claim 23 or 24, wherein in the first step, one or more types of silane compounds represented by general formula (1) are hydrolytically condensed under acidic conditions in an aqueous alcohol solution.

26. The process according to claim 23 or 24, wherein in the second step, a condensation reaction product is obtained by condensing 20% by weight to 99% by weight of the polysiloxane compound (a) and 1% by weight to 80% by weight of the silica particles (b) in an aqueous solution of an alcohol having 1 to 4 carbon atoms, at a pH of 5 to 9, and at 50°C to 100°C (1 atm).

27. The process according to claim 23 or 24, wherein in the second step, after adding at least one type of solvent having a boiling point of 100°C to 200°C (1 atm) selected from the group consisting of an alcohol, ketone, ester, ether and hydrocarbon solvent to the condensation reaction product obtained by condensing the polysiloxane compound (a) and the silica particles (b), the water content of the condensation reaction product is adjusted to 0.001% by weight to 5% by weight by distilling off the added solvent component by distillation.

28. The process according to claim 23, wherein in the third step, after adding at least one type of solvent selected from the group consisting of an alcohol, ketone, ester, ether and hydrocarbon solvent to the condensation reaction product obtained by condensing the polysiloxane compound (a) and the silica particles (b), the silicon compound (c) represented by general formula (3) is reacted with a scavenger in the form of an organic base in an amount 0.5 times to 3 times the number of moles of the silicon compound (c) followed by removing the organic salt formed by washing with an aqueous solution to obtain the silica particle-containing condensation reaction product (A), or after adding at least one type of solvent selected from the group consisting of an alcohol, ketone, ester, ether and hydrocarbon solvent to the condensation reaction product obtained by condensing the polysiloxane compound (a) and the silica particles (b), the silicon compound (c) represented by general formula (3) is allowed to react to obtain the silica particle-containing condensation reaction product (A).

29. The process according to claim 23 or 24, wherein in the third step, after reacting the silicon compound (c) with the condensation reaction product obtained by condensing the polysiloxane compound (a) and the silica particles (b), the solvent component in the reaction product is distilled off to obtain the silica particle-containing condensation reaction product (A).

30. The process according to claim 23 or 24, wherein in the fourth step, a compound (C) having a photopolymerizable functional group in a molecule thereof and/or an antioxidant and/or ultraviolet absorber (D) are further mixed.

31. A production process of a cured product of a photosensitive silicon resin composition, comprising: a step for irradiating the photosensitive silicone resin composition according to any of claims 1 to 22 with light having a dominant wavelength of 200 nm to 500 nm.

32. A cured product obtained according to the process according to claim 31.

33. The process according to claim 31, further comprising a step for baking at 130°C to 300°C.

34. A cured product obtained according to the process according to claim 33.

35. A plastic lens produced according to the process according to claim 31.

36. A replica material produced according to the process according to claim 31.

37. A surface coating material produced according to the process according to claim 31.

# Fig.1

EP 2 604 644 A1

MeMO

EpCyMO

GlyMO

MEDMO

MEMO

StMO

AcMO

# Fig.2

# Fig.3

<div align="center">

**INTERNATIONAL SEARCH REPORT**

</div>

| International application No. |
|---|
| PCT/JP2011/063727 |

| A. CLASSIFICATION OF SUBJECT MATTER |
|---|
| *C08G77/20*(2006.01)i, *C08F299/08*(2006.01)i, *C08G77/14*(2006.01)i, *C08L83/06* (2006.01)i, *C08L83/07*(2006.01)i, *G03F7/075*(2006.01)i |
| According to International Patent Classification (IPC) or to both national classification and IPC |

| B. FIELDS SEARCHED |
|---|
| Minimum documentation searched (classification system followed by classification symbols) |
| C08G77/20, C08F299/08, C08G77/14, C08L83/06, C08L83/07, G03F7/075 |

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
CA/REGISTRY(STN)

| C. DOCUMENTS CONSIDERED TO BE RELEVANT | | |
|---|---|---|
| Category* | Citation of document, with indication, where appropriate, of the relevant passages | Relevant to claim No. |
| A | JP 2005-298796 A (Sanyo Electric Co., Ltd.), 27 October 2005 (27.10.2005), claims; paragraphs [0001], [0036], [0042], [0054], [0057] to [0060], [0094] to [0100] (particularly, table 4, examples 15 to 11) & US 2005/0106400 A1 & CN 1616523 A | 1-37 |
| A | JP 4352847 B2 (Mitsubishi Chemical Corp.), 07 August 2009 (07.08.2009), claims & JP 2005-115264 A | 1-37 |

| ☐ Further documents are listed in the continuation of Box C. | ☐ See patent family annex. |
|---|---|

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 20 September, 2011 (20.09.11) | 27 September, 2011 (27.09.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2851915 B
- JP 3072193 B
- JP 2009102628 A
- JP 4352847 B
- WO 2006035646 A